# EUROPEAN PATENT SPECIFICATION

(11) **EP 0 290 809 B1**
(45) Date of publication and mention of the grant of the patent: **03.04.1996**
(21) Application number: 88105995.0
(22) Date of filing: 14.04.1988
(51) Int. Cl.: G06F 17/50

(54) **Manufacturing system using three-dimensional graphics models**
Herstellungssystem unter Verwendung von dreidimensionalen graphischen Modellen
Système de fabrication utilisant des modèles graphiques en trois dimensions

(30) Priority: 14.04.1987 US 50794
(43) Date of publication of application: 17.11.1988
(73) Proprietor: Northrop Grumman Corporation, Los Angeles, California 90067-2199 (US)
(72) Inventor: Carver, Larry L., Los Angeles Ca. (US); Zamzow, Charles E., Los Angeles Ca. (US); Mladenoff, Donald D., Orange Ca. (US)
(74) Representative: Ebbinghaus, Dieter, Dipl.-Ing.

(56) References cited:
- MACHINE DESIGN, vol. 56, no. 2, January 1984, pages 40-44, Cleveland, Ohio, US; G.D. HODSON: "CAT/CAM takes the guesswork out of mold-making"
- IBM TECHNICAL DISCLOSURE BULLETIN, vol. 16, no. 5, October 1973, pages 1628- 1629, New York, US; P.A. SCHUMANN et al.: "Manufacturing piece part inspection design system"
- ELECTRONIC DESIGN, vol. 30, no. 21, October 1982, pages 225-236, Waseca, MN, Denville, NJ, US; M. SCHLINDER: Systems & Software; "CAD/CAM systems shape up for total automation"

## Description

### BACKGROUND OF INVENTION

This invention is directed to methods and apparatus for precisely producing and precisely assembling a multiple component article of manufacture such as an aircraft.

In the past, the design of aircraft structures was done exclusively utilizing drafting boards and lofting boards. A drawing or a loft board was prepared for each individual structural component specified in the design. For the production of the aircraft when one part is joined to another, appropriate alignment of the connecting elements of these parts must be assured. This has required the use many assembly tools and jigs in order to achieve part alignment.

In presently used aircraft manufacturing procedures, in order to insure that the component parts of an aircraft fit in alignment with one another, it is necessary to make a family of related master tools including full scale mock-ups or "master models" of major components of the aircraft. Other tools including assembly jigs have to be molded from the master model or molded second hand from a prior tool which was itself molded from a master model. Inherently, tolerance build-up always occurs when transfers are made from the master model or from an intermediate tool.

Master tools have inherent problems. They are easily damaged and can be affected by temperature and humidity. A transfer taken from a master tool at one time may differ from a similar transfer taken from that master tool at a different time because of existing conditions at the time the transfers are taken. Further, in master models, because of their sheer size, a master moldline surface is often independent of the actual engineering design criteria and is extremely difficult to reproduce to the tolerances sought.

Since present tools for aircraft manufacture are fabricated by a multi-step procedure derived from a master model, the degree of dimensional accuracy achievable is restricted by the material properties of the tools as well as processing techniques. Dimensional accuracy cannot be maintained throughout the multi-step transferring process and, as a result, inconsistency in assembly, production, or intermediate tools has been a significant problem.

In an article titled "CAD/CAM TAKES THE GUESSWORK OUT OF MOLD-MAKING" in Machine Design, Vol. 56, Jan. 1984, No. 2, Cleveland, Ohio, pp. 40-44, G.D. Hodgson discusses various aspects of CAD/CAM in mold-making as applied to single part molding. CAD definition of molds and selection of predetermined fixtures and jigs from system mennes is implemented in order to arrive to the final molding configuration.

In view of the problems addressed above, it is evident why large precision structures such as aircraft are very costly and require long lead times for their development. The use of composite materials in an aircraft or other structure leads to improved characteristics of that aircraft or structure. However, it also contributes to further manufacturing obstacles in addition to the ones discussed which are already inherent in the manufacture of the aircraft.

### BRIEF DESCRIPTION OF THE INVENTION

This invention, as claimed, provides for new and improved methods and apparatus for precisely producing and assembling a multicomponent article of manufacture.

For illustration of the invention there is provided a method of manufacturing an aircraft by constructing a definition of the aircraft in a computer memory. The definitions of a plurality of tool means are then defined in the computer memory in operative association with the definition of the aircraft. These definitions are downloaded from the computer memory to a means for forming tools. This means is operated to form the respective tools which, in turn, are then used to form component parts of the aircraft and assembly structures used to assembly these component parts into the aircraft.

For constructing the definition of the aircraft a 3-dimensional graphics computer system containing a graphics data model of the aircraft in a data base within the computer system can be utilized. The computer system can include means for defining a graphics virtual surface of the aircraft in the data model and further includes means for defining a graphics virtual tool in the data model. The virtual tool includes at least a portion of the graphics virtual surface.

The respective means for defining the graphics virtual surface and for defining the graphics virtual tool can include computer assisted tooling design software for defining a sequence of machine operations for machining a tangible part. Further, it can include computer assisted tooling manufacturing software for inputting a sequence of machine operations to a tool forming means whereby the tool forming means forms a tangible tool which is a mimic of the graphics virtual tool in the data model of the article.

The tool forming means can be selected as a tool from one of a set of tools including numerically controlled machine tools, numerically controlled lasers cutters, numerically controlled robots, computer numerically controlled machine tools, computer numerically controlled lasers cutters and computer numerically controlled robots.

The data model of the aircraft can include a wire model surface definition of the aircraft. Further, the data model can be generated to include coordinate points for precisely locating the definition of the aircraft in a three dimensional coordinate system, and also can include a data sub set coordinate means associated with the virtual tool for precisely locating the surface of a tangible tool in the three dimensional coordinate system.

By downloading at least a portion of the data sub set to a microprocessor controlled measuring means which can measure target points in three dimensional space and then operating the microprocessor controlled measuring means to measure three dimensional coordinating points on a tangible tool, an aircraft component or the aircraft, the measured coordinating points can be compared with the data sub set to verify a relationship between a tangible tool or a component part of the aircraft with the data model of the aircraft.

In accordance with the invention, a tool having a defined surface has a plurality of profile boards and at least one connector board. At least a portion of the profile boards have a profile edge. These profile edge form at least a part of the defined surface of the tool. Each of the profile boards further includes locator means for positioning the profile board with respect to the connector board. The connector board also includes locator means for positioning the connector board with respect to each of the profile boards. The respective locator means each include a locator edge on the respective profile boards or the respective connector board. The connector board is positionable against the locator edge on the respective profile boards; likewise, the profile boards are positionable against the locator edge on the connector board. Both the locator board and the connector board are then kept in their respective locations by a means for maintaining the profile boards and the connector board positioned with respect to one another. The defined surface of the tool can comprise a mold line surface with the profile edges of the profile boards being located in this moldline surface.

These and other features, advantages and objects of this invention are disclosed in detail herein with reference to the following detailed description and claims, when taken with the accompanying drawings, of which:

### BRIEF DESCRIPTION OF THE DRAWINGS

Fig. 1 is an isometric view of a prior art master tool utilized in the construction of an aircraft;
Fig. 2-a is an isometric view of portions of the master tool of Fig.1 seen during the construction of this mater tool;

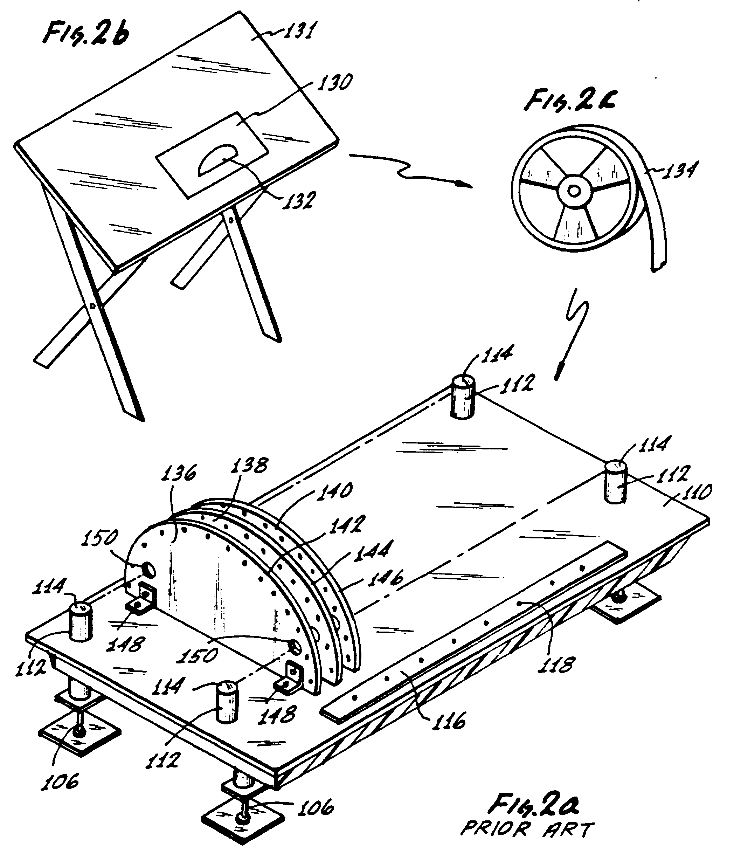

Fig. 2-b is an isometric view of a representational drafting board with a drawing for one of the component parts of this master tool;
Fig. 2-c is a representational tape for a numerically controlled machining tool for forming the component part;

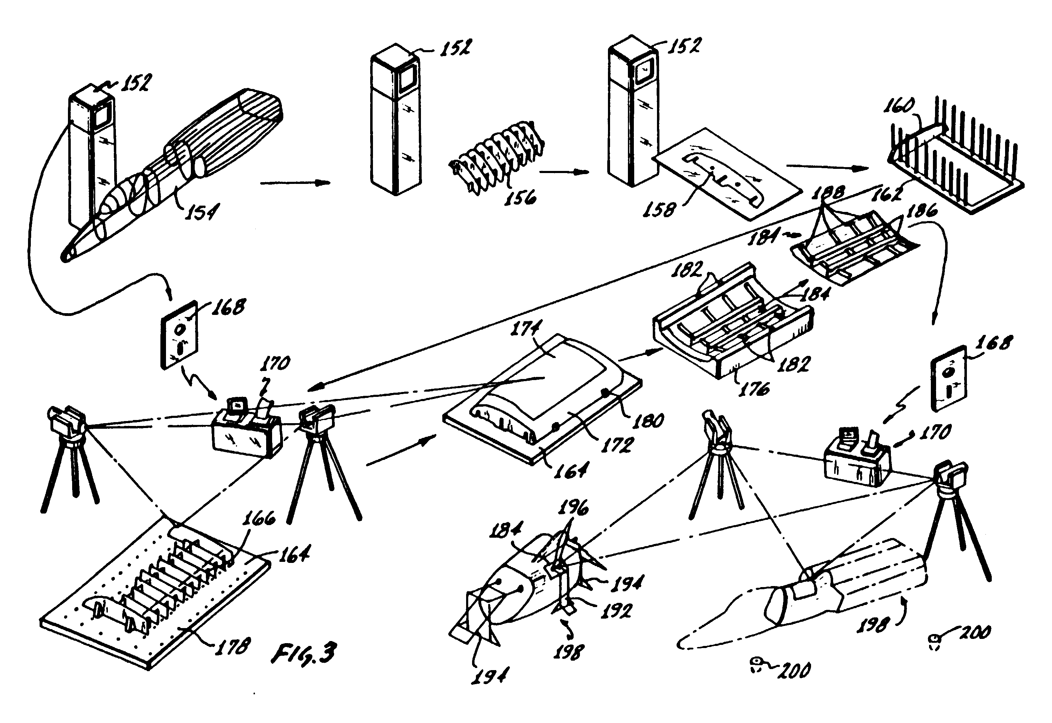

Fig. 3 is a schematic flow chart showing isometric views of certain devices and components utilized during a manufacturing process of this invention;

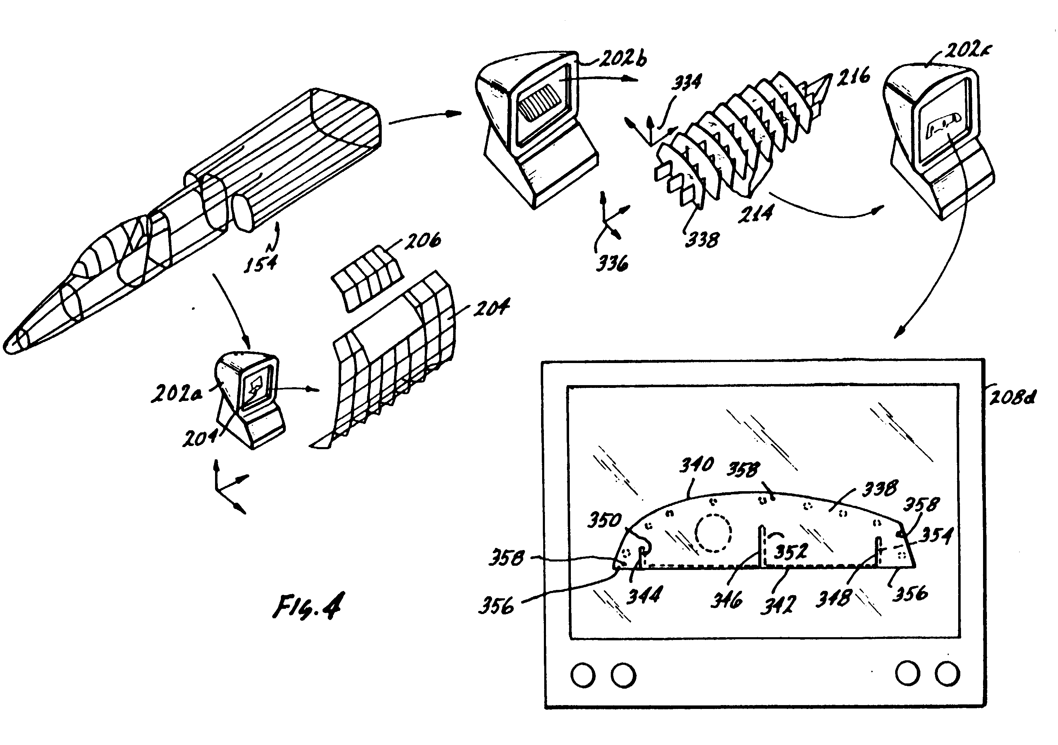

Fig. 4-a is a schematic flow chart similar to Fig. 3 showing isometric views of some of the components of Fig. 4 as well as additional components;
Fig. 4-b is an enlarged elevational view of one of the components of Fig. 4-a;

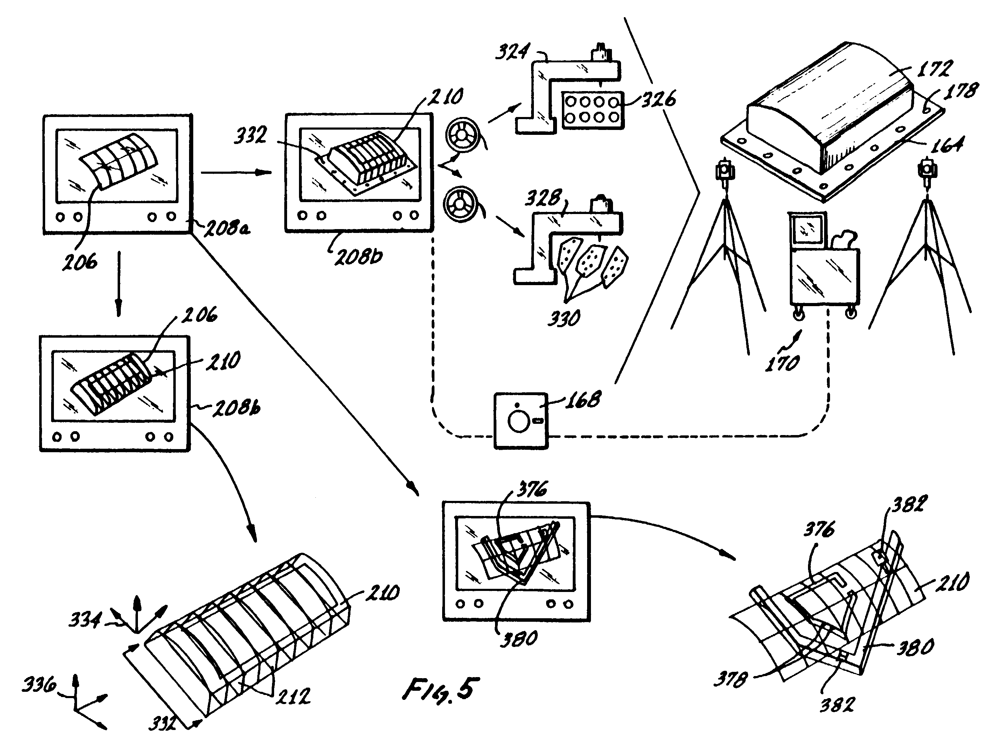

Fig. 5 is a schematic flow chart similar to Figs. 3 and 4 showing isometric and elevational views of certain of the components of Figs. 3 and 4 as well as further components;

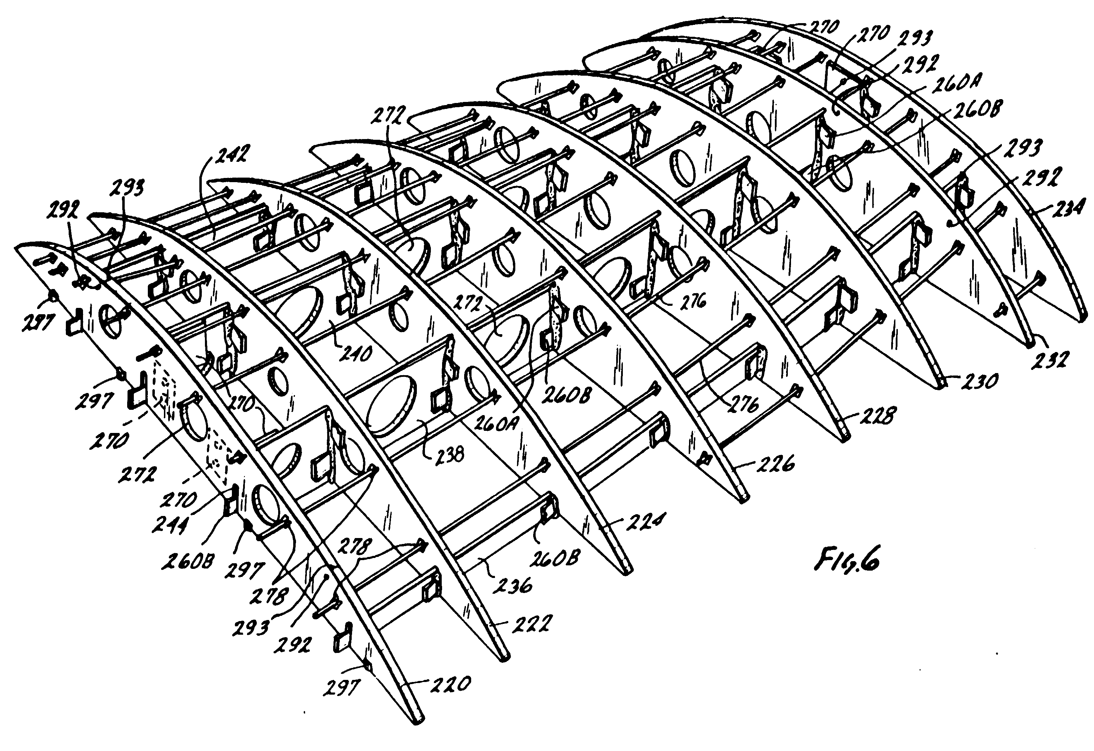

Fig. 6 is an isometric view of a tool utilized during the manufacturing process of Fig. 3;

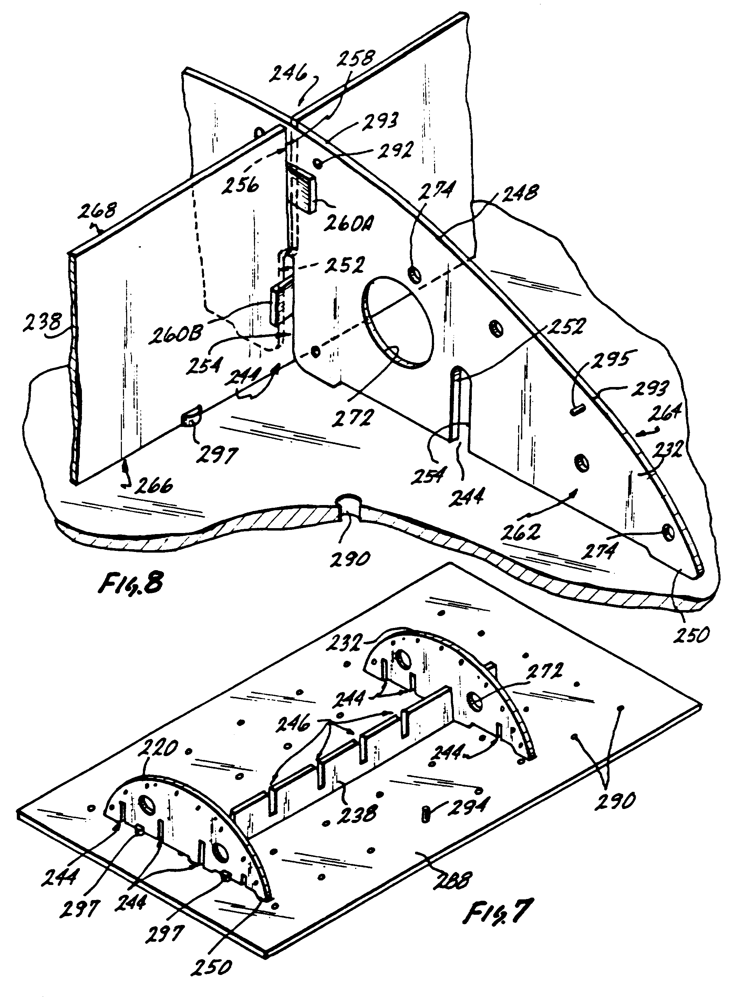

Fig. 7 is an isometric view of a surface and portions of the tool of Fig. 6 during assembly of the tool of Fig. 6;
Fig. 8 is a fragmentary isometric view showing details of certain of the components of Fig. 6

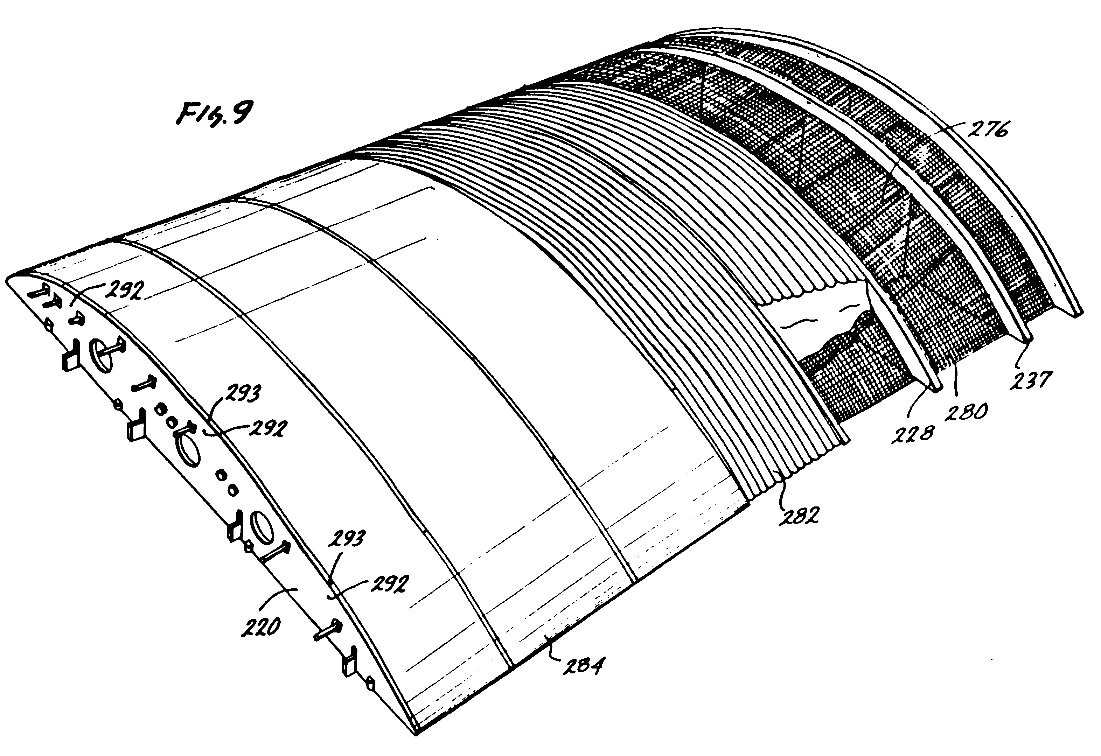

Fig. 9 is an isometric view of the tool of Fig. 8 showing stepwise modifications of that tool to convert it into a further tool;

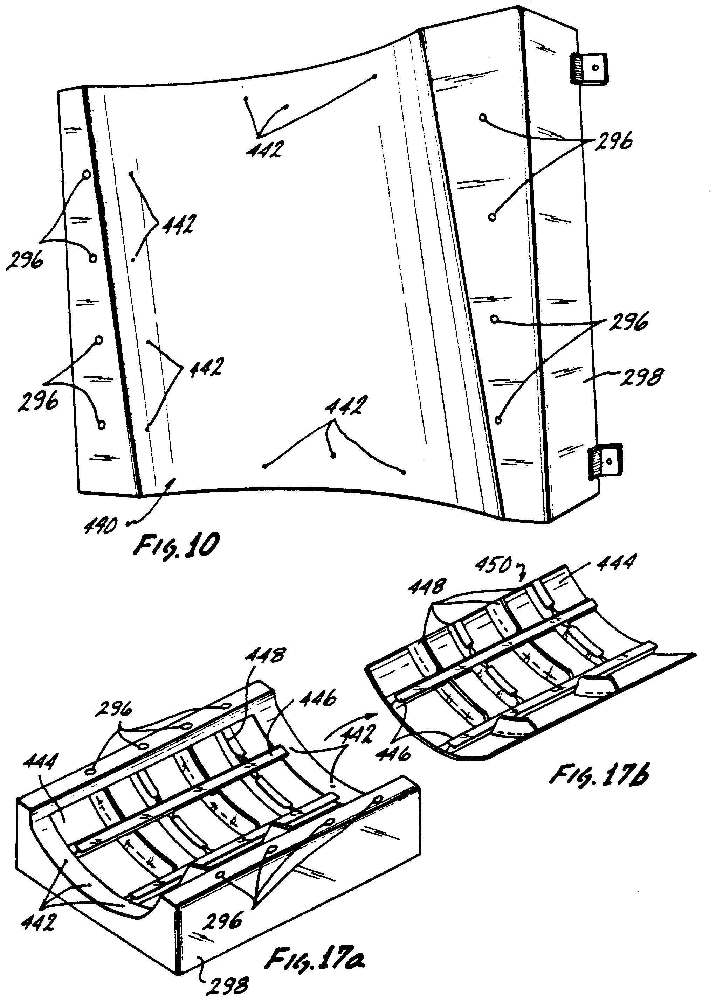

Fig. 10 is an isometric view of a further tool utilized during the manufacturing steps of Fig. 3;

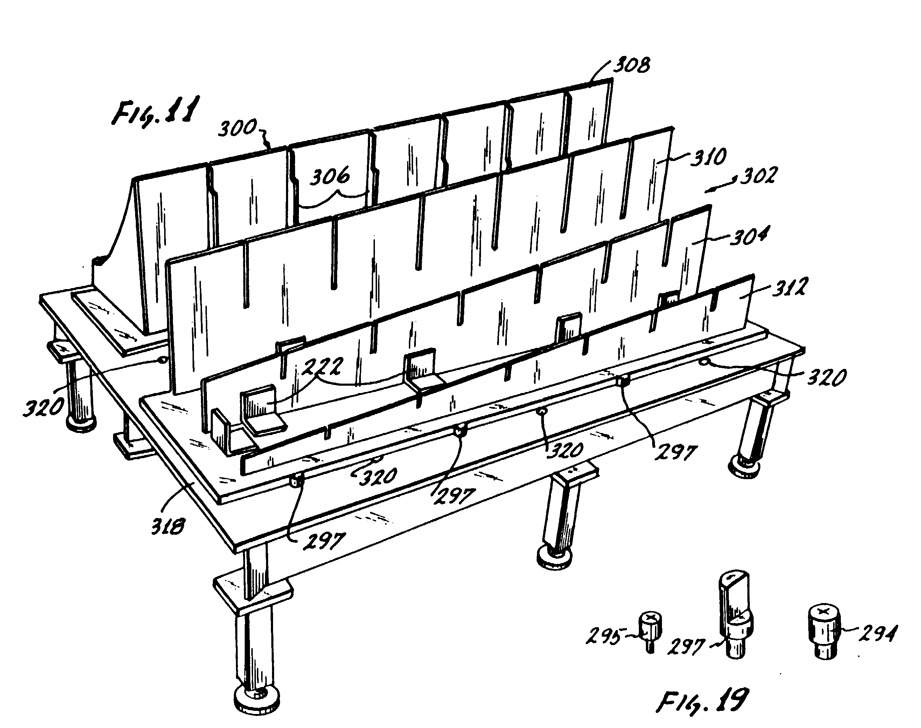

Fig. 11 is an isometric view of an alternate embodiment of a tool utilized during the manufacturing steps of Fig. 3;

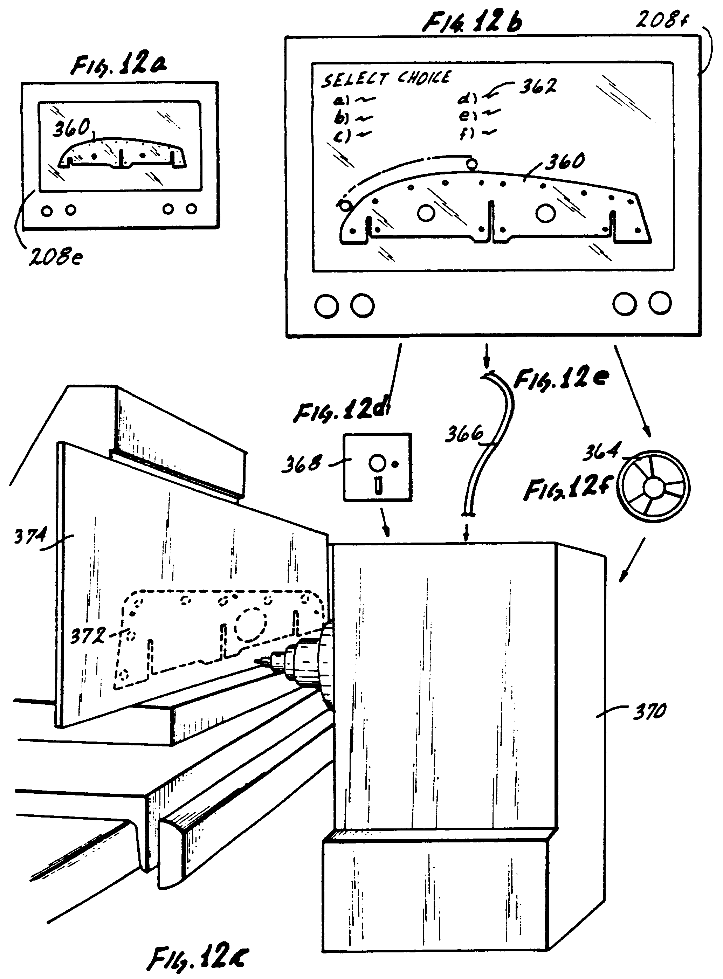

Figs. 12-a and 12-b are elevational views of certain components which are related to components seen in Figs. 4 and 5;
Fig. 12-c is a schematic isometric view of a representational numerically controlled milling machine and a part thereon;
Figs. 12-d, 12-e and 12-f are schematic elevational views of certain components which connect the structures of Figs. 12-b and 12-c;

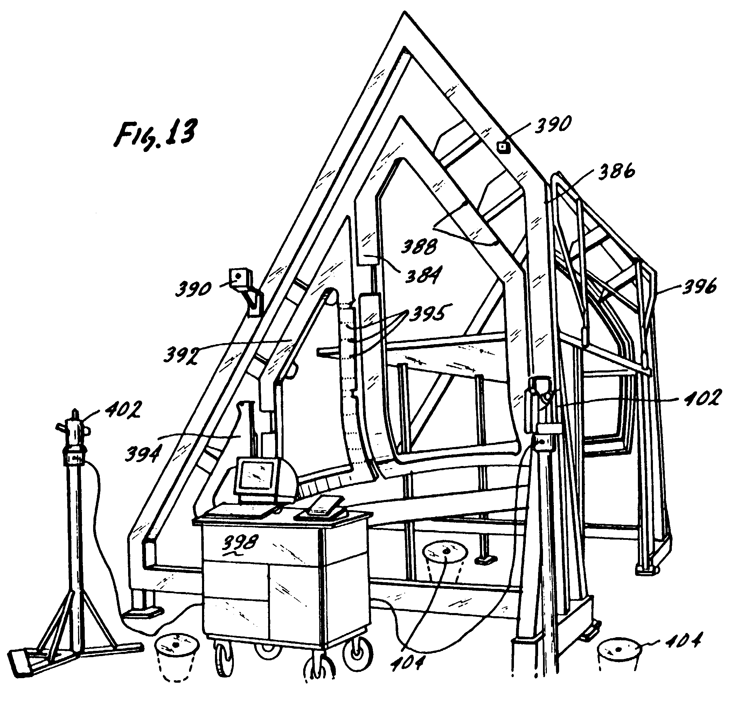

Fig. 13 is an isometric view of a further tool utilized for the construction of aircraft using the manufacturing process of Fig. 3;

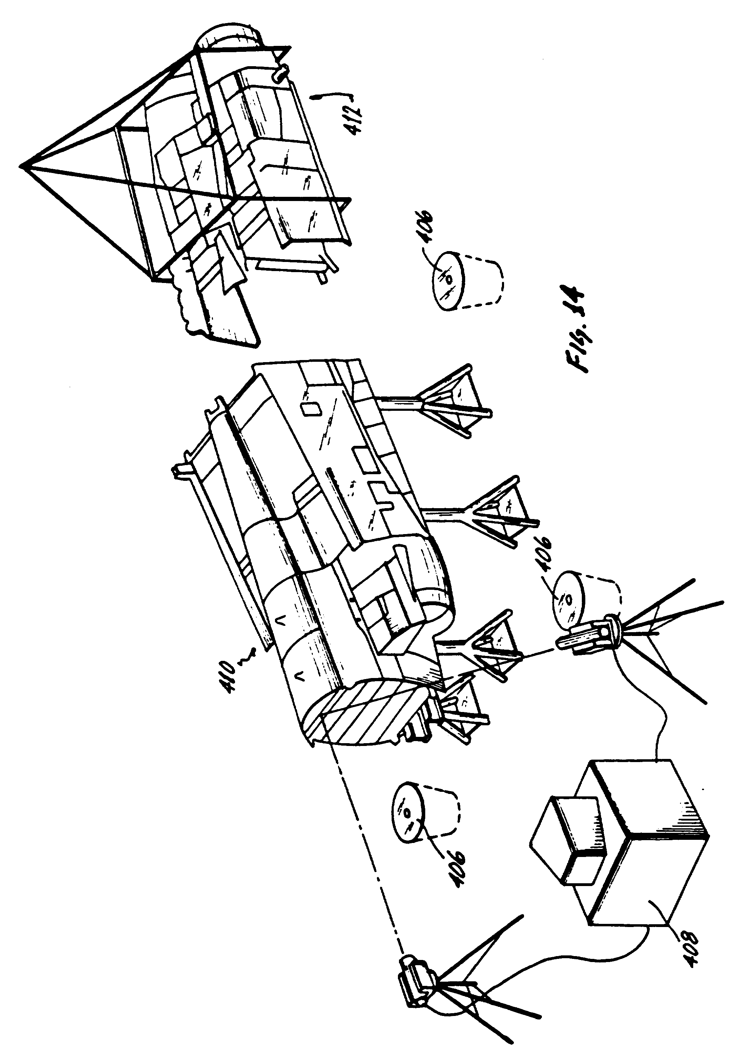

Fig. 14 is an isometric view of assembly steps during the manufacturing of an aircraft using the manufacturing process of Fig. 3;
Fig. 15 is an isometric view of a partially completed tool and associated apparatus used during the manufacturing process of Fig. 3;

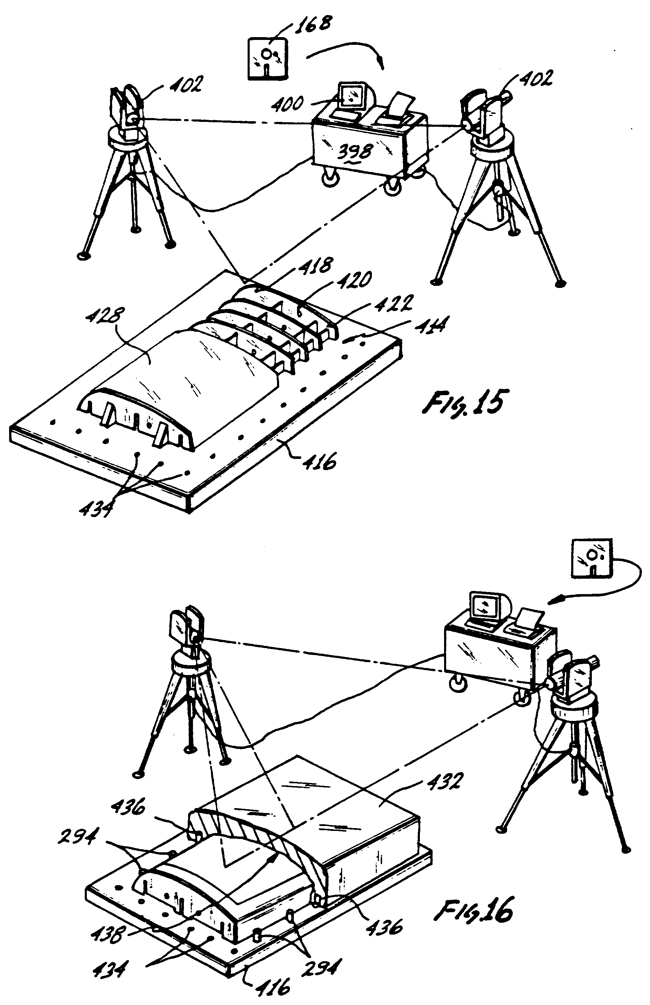

Fig. 16 is an isometric view showing the completed tool of Fig. 15 plus a fragmentary view of a further tool and associated components utilized during the manufacturing process of Fig. 3;

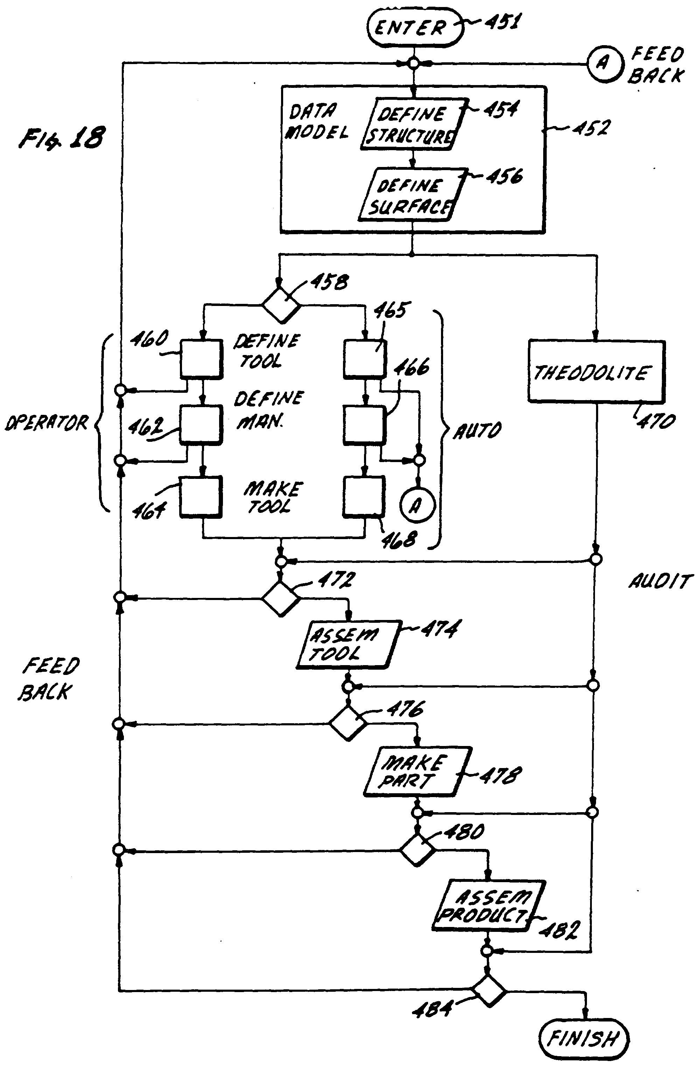

Fig. 17-a is an isometric view of a tool similar to the tool of Fig. 10 including a part located on this tool;
Fig. 17-b is an isometric view of the part of Fig. 17-a exploded away from the tool of Fig. 17-a;
Fig. 18 is a schematic flowsheet of a process of the invention; and
Fig. 19 is an isometric view of certain positioners and targets utilized in the process of other of the figures.

### DETAILED DESCRIPTION OF THE INVENTION

For use in this specification in describing this invention, an aircraft will be used as illustrative of an article of manufacture of the invention. In defining an aircraft system the terminology "moldline" will be considered as being synonymous with the outside skin or exterior configuration of an aircraft. It is of course realized that a "moldline" could also be applied to further surfaces other than just the outside skin. Prior to describing this invention, a more detailed analysis of certain aspects of the currently practiced methods of manufacturing aircraft structures will facilitate the understanding and appreciation of the invention.

Current aircraft manufacturing practice relies on the use of "master models" as the ultimate reference for the production of and fit of the component parts of the aircraft. These "master models" are full scale physical structures or models which are manufactured to mimic the engineering data as closely as possible. Because of the methods used in their construction and their size, it is very difficult, costly and time consuming to construct these "master models" to the tolerances necessary for an aircraft system.

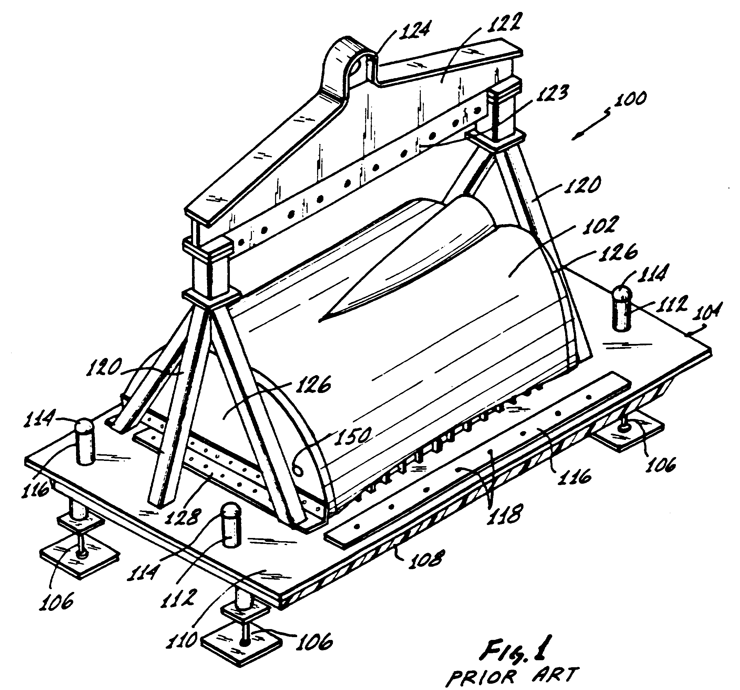

Figure 1 illustrates a typical "master model" which would be utilized in presently practiced methods of aircraft manufacture. The master model 100 of this figure duplicates a major section of the fuselage of a typical high performance aircraft.

The master model 100 includes many components, all of which are necessary to its construction and stability. These components allow it to serve as the "master" reference for individual components of the aircraft. Other molds such as master female molds are also made with the master model 100.

Before the master female molds can be formed against the master model 100, reference marks must be meticulously and time consumingly laid out by hand and eye on the moldline surface 102 of the master model 100 utilizing typical classical measuring instruments such as levels and scales and hand operated transits.

The master model 100 is constructed with a base 104 which is supported on legs collectively identified by the numeral 106. The base 104 has to be formed as a structure which will support and hold the remainder of the master model 100 as stable and permanently fixed as possible over the life time of the master tool. Typically, the base 104 includes supporting I beams 108 attached to a steel base plate 110. Generally the steel base plate 110 is of a thickness of one inch or greater. As is evident, just the base 104 itself constitutes a heavy massive structure.

Permanently attached to the base 104 are a plurality of "candlesticks" collectively identified by the numeral 112 which are used to support optical targets such as cup mounts or targets 114. The cup mounts 114 are used as target points to "sight" with a hand operated optical device to level the base 104 and to serve as reference points on the master model 100. The legs 106 are adjustable for initially leveling the base 104 during construction of the master model 100.

Also located on the base plate 110 is a reference plate 116 which has a plurality of holes collectively identified by the numeral 118 positioned at precise locations in the reference plate 116. These are utilized to correlate the master model 100 with other structures such as adjoining master tools (not separately shown or identified) or the above mentioned female masters made from the master model 100.

Pillars collectively identified by the numeral 120 are fixed to the base 104 at both ends of the master model 100. A detachable beam 122 which can be connected to the pillars 120 supports a further reference plate 123. A ring 124 is located on the beam 122. The ring 124 serves as an appropriate attachment point for a derrick or crane to move the beam and reference plate 123 from the remainder of the master model 100 when it is necessary to do so to have direct access to the moldline surface 102.

The master model 100 further has two end plates collectively identified by the numeral 126. The end plates 126 are fixedly attached to the base plate 110 with channels 128. As is the base plate 110, the end plates 126 are also formed of heavy plate. The end plates abut against the pillars 120 to give stability against lateral movement along the longitudinal axis of the master model 100. Since all of the components of the master model 100 described so far are made of metal, they are subject to thermal instability.

Referring now to Figure 2 the formation of the moldline surface is described. In Figures 1 and 2, like numerals will be utilized to identify like parts common to the two figures.

The moldline is formed using a plurality of "profile boards" which represent sections through the moldline surface. Figure 2-b shows a drawing 130 on a drafting board 131 of one such profile board 132. The drawing 130 would be prepared by taking a section cut off of a master assembly or sub-assembly drawing of the aircraft under construction. After the drawing 130 for the individual profile board 132 is prepared, it is passed on to an NC programmer.

The NC programmer inputs the data of the profile board 132 specified by the drawing 130 to an APT-AC processor. While certain software has been developed to assist the NC programmer the NC programmer must still determine all of the parameters for the tooling operation. This is a time consuming task. In any event, a postprocessor generates a mylar tape 134, shown in Figures 2-c, which is fed to an NC machine tool to direct the cutter path of the machine tool.

Shown in Figure 2-a are three individual profile boards 136, 138 and 140 which have been cut on an NC machine tool. They each contain one profile edge, edges 142, 144 and 146 respectively. These profile edges have been cut to a specified tolerance on the NC machine tool to match, as accurately as possible, the profile specified for the "profile board" (as for instance, profile board 132) on the respective drawings which defines the respective profile board. Other than the profile edges 142, 144 and 146, the remainder of the profile boards 136, 138 and 140 are not cut to an exacting tolerance but only to a general tolerance.

The profile boards are now positioned and fixed one at a time onto the base plate 110. After the base plate 110 is assembled, leveled, and the measuring cup mounts 114 located thereon, profile board 136 is exactly positioned on the base plate 110 independently locating the profile surface 142 in the X axis, the Y axis and the Z axis. It is then fixed in place on the base plate 110 with angle brackets collectively identified by the numeral 148. Note that the profile board 136 (as well as all other profile boards) must include sight holes, collectively identified by the numeral 150, in order to optically align between the cup mounts 114 on the respective ends of the master model 100.

Once the profile board 136 is positioned, its position must be independently verified by an audit by inspection personnel. This is necessary because of the criticality of the master model 100 to the finished aircraft throughout the life time of the production of the aircraft or replacement parts for that aircraft. When all are satisfied that profile board 136 is positioned as accurately as possible in all of the X, Y and Z axes, the next profile board 138 can be placed.

As with the first profile board 136, profile board 138 must be positioned individually so that its profile surface is correctly located in all of the X, Y and Z axes, and to insure that it is correctly located with respect to the profile board 136 (or boards) already in position. Profile board 138 is then fixedly attached to the base plate 110 with angle brackets 148, and its position verified by an independent audit by inspection personnel. This is repeated for the profile board 140 and all remaining profile boards. As is evident, this is a time consuming and, therefore, expensive process. Long lead times are necessary to construct these master tools such as master tool 100.

Once all of the profile boards are located on the base plate 110, and certain supporting rods and supporting mesh added (as will be described in greater detail below in discussing an embodiment of the invention), plaster is "faired-in" between the profile boards by using the profile boards as a quide for a fairing tool pulled across the profile edges of the profile boards filling the space between the profile boards with plaster. This forms the moldline surface 102 of the master model 100.

The moldline surface 102 master model 100 is then once again hand inspected using splines and feeler gauges. This inspection, however, is not an inspection back to engineering specification. It is only to insure that there are not high or low areas on the moldline surface 102 of the master model 100. If the master model is satisfactory, its surface is marked with identifying locations or holes which will be used when other tools are made from the master model or are checked against the master model.

As is evident from the above construction, the master models are very heavy and generally cannot be oriented in any orientation except the orientation they are constructed in. Further anything which must be done in conjunction with them must be done at their storage site.

The present invention dispenses with the necessity of the hard master tool concept. In its stead, it utilizes a "data model" of a structure which resides in computer memory or computer storage. This data model provides an engineering definition of the structure as well as additional information which is added to the data model. Since the data model resides in computer memory, for any and all operations in designing, manufacturing or assembly associated with the structure, access is always made back to the computer memory definition for information.

For the want of a mnemonic identifier, the terminology "data model" is primarily utilized in this specification. Interchangeably, "computer memory master design definition", "engineering electronic model", "data base graphics model", "assembly data model", "3-D graphics model" or even "soft master" might be considered equivalent terminology for the "data model".

Further, for the purposes of this specification the terminology "computer memory" or "computer storage" is defined to be that of the typical definition utilized in computer science. The terms "memory", "storage" or "store" are considered synonyms. "Memory" or "storage" can be main or active memory in the usual computer science sense, or secondary memory also in the usual computer science sense. Except during active interfacing of the memory definition (the data model) of the structure to be built, for most purposes the memory definition (the data model) of the structure will exist in the normal secondary memory, i.e. magnetic drums, disks, tapes or optical memories or chip memories like ROM's, PROM'S, virtual RAM memories, etc.

After input of the original engineering definition of the structure into the data model in computer memory, access back to the data model in computer memory can be made for all types of aircraft manufacturing procedures such as: the production of bonding tools, which are used to form and cure composite parts; for the production of assembly jigs for orienting component parts of the structure to one another; for the production of machined tools; for material ordering and processing; for the auditing or inspection of component tools and parts; for the assembly of component tool parts; for the assembly of the component parts into the aircraft structure; and other operations and procedures as will become evident from this specification.

In addition to the engineering definition of the structure to be built, the data model can also include further information associated with the structure which is added to the data model throughout the manufacturing steps of the structure. With each step utilized in the entire manufacturing process of the structure, the same dynamic computer memory definition of the structure is utilized. This computer memory definition is not subject to environmental conditions and it can be shared or duplicated so that it is available to many users at one time.

A data model of a structure of this invention inherently includes an exact engineering description of the structure since, among other things, it is the engineering definition of the structure. This is opposed to the master tool concept which was fabricated as best as possible to "represent" the engineering definition of the structure. And contrary to the hard master tool concept, a change can be made to the data model definition of the structure and be reflected through the totality of the manufacturing process of the structure.

The data model replaces the various master models and other master tools, and in their stead it uses a single mastering source for all of the manufacturing processes and assemblies. Further, since component parts of the data model can be utilized by many users at the same time, parallel manufacturing and assembly can be achieved. Thus, as opposed to the old hard master concepts, an assembly jig can be constructed concurrently with a bonding tool since neither is dependent on the other for its construction and assembly. This is diametrically opposed to the old hard master concept wherein a gauging master was necessary before the assembly jig could be completed.

With this invention, in addition to the engineering definition of a structure, data representing actual physical components parts, tools or jigs, as formed, can also be stored as a component part of the data model with the engineering definition. Because of this, all deviations are always known for archival and quality control purposes. Additionally, if desired, the actual engineering definition could be changed to reflect changes or upgrades in component parts, and these changes would be propagated to other tools, jigs, assembly instructions, and the like. Also parts and tooling can be constructed and assembly effect in simulation to uncover any construction problems which may not be inherent during design.

The data model of the structure is initiated in an appropriate computer system by first entering the engineering definition of the structure. Virtual tools necessary to fabricate the component parts of the structure are then also defined in the data model. These data model definitions can then be downloaded to emulating means for the production of the component tool parts. Further, these definitions are downloaded to domain interface means for comparing the tools, assembly jigs and the like, and actual physical component parts, to the data model definition of the structure or the data model definition of associated tooling structures which are also created in the data model. The definition downloaded to the domain interface means can also be utilized for assembly of the component parts into the structure or parts of the structure.

Since composite materials are assuming greater and greater importance in aircraft manufacture, the construction of tools for forming bonding tools, and the bonding tools themselves, will be mainly used to illustrate the invention. The tools for forming bonding tools and bonding tools represent both direct image copies of the moldline of an aircraft and complementary image copies. As a further illustration of the complementary image of the moldline of an aircraft, a further embodiment will illustrate the construction of an assembly jig utilizing the principles and concepts of the invention.

Figure 3 schematically shows the overall construction of an aircraft from conception to finish and highlights the above described illustrative embodiments. Certain of the steps and structures pictorially presented in Figure 3 will be expounded upon in greater detail and referenced in other figures of the drawings. Where indicative of continuity between different figures, "like" numerals will be utilized to identify like or "similar" parts. When certain structures or processes are described in greater detail than as described in Figure 3, further numerals will be utilized to identify parts similar to those shown in Figures 3 or other figures.

In the upper left hand corner of Figure 3, a computer system 152 is utilized to create an engineering definition or master design definition of an aircraft 154 in a data base in the computer system 152. At this point in time, the aircraft 154 is only a virtual aircraft since it only exists as the engineering definition in a data base in the computer system 154. This forms the initial entry into the data model for the aircraft structure.

The computer system 152 is chosen as a computer system running a 3-dimensional graphics software program and, as such, the data model or master design definition is a 3-dimensional (for brevity hereinafter referred to as 3-D) graphics design definition. Such a definition will include coordinate points precisely locating the data model or master design definition in a 3-D coordinate system.

This is typically achieved in a 3-D graphics software program using X, Y and Z coordinate points as well as appropriate locating vectors where necessary. Typically, a 3-D graphics software program will utilize appropriate data structures for defining particular points in the data base of the graphics program. By utilizing algorithms in the graphics program, other points in the structure can be defined and generated by the graphics program. Typically, the graphics program will utilize appropriate vector and matrix routines whereby a structure can be rotated or otherwise moved in computer memory and can be dimensioned whereby the coordinates for any one point are known with respect to other points.

In any event, the data model will be created in the computer system 152 and stored in an appropriate file or files in a data base in computer memory. Further, a data set or data sets of this data model, or portion thereof, from the data base file or files can be downloaded from memory through appropriate output devices associated with the computer system either as memory words (that is the particular word size in bytes for the computer system) on appropriate data buses or input/output (I/O) data ports, as appropriate memory images (magnetic or optical data read/write data transfer), or by creation of hard copies of the same (printer output, etc.). Additionally, many users can be networked into the data model for parallel interaction with the data model.

As is shown and discussed in greater detail below in referring to Figures 4 and 5 and other figures, an appropriate component section of the aircraft structure is selected and a virtual tool 156 for constructing the selected section is defined in the data model within the computer system 152 (or other equivalent computer system). A virtual component part 158 of the virtual tool 156 is further defined in the data model.

The virtual part 158 and the remainder of the parts of the tool 156 (also defined in the data model in a like manner) are constructed by a tool making means (not separately shown or numbered in Figure 3) to form a corresponding actual tangible part 160 and other corresponding parts not separately shown or numbered. The part 160, along with the remaining corresponding parts, are collected in a kit rack 162 for assembly. When all of the component parts are collected in the kit rack 162 for assembly, they are assembled together, as for instance, on a grid surface 164 into bonding tool formation precursor tool 166.

A copy from the data model of the data set containing the definition of the virtual tool 156 is downloaded from the computer system 152 for transfer, as is represented by floppy disk 168. The data set for the virtual tool 156 is transferred to a computer aided theodolite system 170, as for example via the floppy disk 168.

The computer aided theodolite system 170 and the floppy disk 168 serve as one example of a domain interface means for comparing the tangible tool 166 to its data model definition defined by the virtual tool 156 in the data model. As will be described in greater detail below, this is done utilizing 3-D coordinating points on the tangible tool 166 or the surface 164, or both, and comparing them to the coordinate points in the 3-D coordinate system of the data model in the data base created by the 3-D graphics software running on the computer system 152.

The surface of the bonding tool formation precursor tool 166 is faired-in with plaster to complete the bonding tool formation or transfer tool 172. This forms a moldline 174 which is an image of a section of the virtual aircraft 154 in the data model. This section of an aircraft is constructed via a tangible tool (the tool 172) which corresponds to a virtual tool, virtual tool 156, in the data model. The virtual tool in turn corresponds exactly to the engineering specification of the aircraft in the data mode.

As with the bonding tool formation precursor tool 166, the moldline image 174 on the bonding tool formation tool 172 can be compared to its virtual counterpart, a virtual surface on the virtual aircraft 154 in the data model by interfacing between the data model and the surface 174 with the domain interface means characterized by the computer aided theodolite 170 and the floppy disk 168.

By building the bonding tool formation precursor tool 166 on a surface which has known spatial identifiers 178 on it, i.e. a grid pattern standard, and coordinating, via the computer aided theodolite system 170, these spatial identifiers 178 with the data model, the precise location of coordinating points on the bonding tool formation tool 172 and these spatial identifiers 178 can be established and can be referenced to the data model.

A bonding tool 176 can now be molded on the bonding tool formation tool 172. However, if the bonding tool 176 is molded not only from the bonding tool formation tool 172 but is also partially formed against the surface 164, and if prior to molding the bonding tool 176 on of the bonding tool formation tool 172 and the surface 164, precision target pins 180 are inserted in the spatial identifiers 178 on the surface 164, then when the bonding tool 176 is formed on both the bonding tool formation tool 172 and the surface 164, the target pins with assigned values will transfer precise location holes 182 to the bonding tool. These location holes 182 can now serve to reference the bonding tool 176 to the data model.

Since the spatial identifiers were coordinated to the data model and the 3-D coordinate system in which the virtual aircraft 154 is defined, when they transfer via the target pins 180 to the bonding tool 176, they become target holes 182 with known values. That is, the target holes 182 are precisely known in 3-D space with respect to the master design definition of the virtual aircraft 154. Since the target holes 182 are known in 3-D space, the computer aided theodolite system 170 can be used to locate any further points which are desired on the surface of the bonding tool 176.

Now when a composite component part 184 is formed on the bonding tool 176, component pieces of the part 184, such as longerons, collectively identified by the numeral 186, and ribs or stiffeners collectively identified by the numeral 188, can be precisely positioned on a composite skin 190 via the target holes 182 or other identifiers (discussed below) on the bonding tool 176.

In the same manner as the virtual tool 156 was defined in the data model in 3-D computer graphics, a virtual assembly tool (not separately shown or numbered on Figure 3) could also be defined. Instead of it containing a surface (a virtual surface corresponding to the skin panel 190), it would include locator points abutting against or cutting into that surface (points complimentary to or intersecting that virtual surface). In any event, it would be defined, and from its definition component parts would be machined and built in a manner equivalent to the bonding tool formation precursor tool 166 to form an assembly jig 192.

This assembly jig 192 is used in conjunction with other assembly components, collectively identified by the numeral 194 in Figure 3, to assemble component parts, including the component part 184 into an aircraft structure 198. The positioning of the component part 184 on the assembly jig is done utilizing the computer aided theodolite system 170 and a data model data set on the floppy disk 168. To facilitate this, known locators 196 are specified and located on the assembly jig 192 as known positions in 3-D space (in a manner as described for the spatial identifiers 178 or target rod 180) and the computer aided theodolite system 170 is used to align target points or coordinating points on the component part 184 with corresponding locators 196 or coordinating points on the assembly jig 192.

Finally, as is seen in the lower right hand corner of Figure 3, the totality of the aircraft 198 is assembled with the aid of a copy of the data model containing the definition of the virtual aircraft 154 which has been downloaded as a data set to the floppy disk 168 and inputted into the computer aided theodolite system 170. To facilitate this, known spatial grid points, collectively identified by the numeral 200, (equivalent to the spatial identifiers 178) can be located within the assembly cell as for instance in the assembly bay floor and entered into the 3-D coordinate system of the computer aided theodolite system 170.

The aircraft 198 is assembled by utilizing virtual images of the target points 200 in the computer memory as coordinating points between the virtual image (the virtual aircraft 154 in the data model) and actual aircraft 198. This is done by coordinating the virtual images of the target points 200 to the tangible target points 200 via the computer aided theodolite system 170. The virtual images of the target points 200 are downloaded as a data set from the data model to the floppy disk 168. The floppy disk then serves as the transfer medium for input of these virtual coordinating points to the theodolite system 170.

Referring now to Figures 4 and 5, as noted, where appropriate, like numerals will be utilized in describing like and nearly alike virtual and tangible parts seen on Figure 3.

The virtual aircraft 154, shown in both Figures 3 and 4, is constructed utilizing an interactive 3-D graphics CAD program. Normally a design engineering team would construct the virtual aircraft 154 using a CAD program or programs and interface devices such as light pens, function key boxes, graphics or digitizing tables, tablets or boards, or a computer mouse. Of course all of these would also be utilized in conjunction with keyboard entered commands. Insofar as CAD programs of this type are commercially available and the above interface devices are also, a detailed description of the operation of a particular program or device is not deemed necessary to the understanding of this invention.

A 3-D CAD program or programs, such as CATIA (IBM Corporation) or NCAD and NCAL (Northrop Computer Aided Design and Northrop Computer Aided Lofting, Northrop Corporation, Hawthorne, CA) would be suitable to define the master engineering definition of the aircraft 154 in 3-D graphics in the data model. This master engineering definition is created and stored in a file or files in a data base. In inputting the engineering definition, other software can be used to assist in the design chores. For instance, a loft data program like NORLOFT (Northrop Corporation). In addition, a known CADAM 2-D graphics software (available from the Lockheed Aircraft Corporation) could also be utilized to produce dimensioned drawings if such drawings were desired for manufacturing purposes. Suggested as other CAD 3-D design software might be CADD (McDonald Douglas Corporation) or other appropriate CAD software.

The master engineering definition, or other entries in the data model, would be done on a suitable computer system such as an IBM 3090-200 mainframe, an IBM 3081 mainframe, or an IBM 4381 mainframe using an appropriate operating system such as the IBM MVS-XA (Multiuser Virtual Storage-Extended Architecture). Engineering data or other data input to the data model would typically be done at an appropriate work station such as an IBM 3278 terminal or an Adage workstation equipped with appropriate interface devices, as described above.

The workstation or workstations would be appropriately interfaced with the mainframe using appropriate software such as the IBM TSO (Timesharing Option) software which allows both downloading and uploading between the respective computer devices. This provides the workstation with a microcomputer working environment while still providing access to the mainframe library allowing the generation and use of a "single source" information data base for the data model.

Other CAD systems such as the ME Series 30 CAD (Hewlett-Packard) are designed to run on specific computer hardware such as Hewlett-Packard mini-computers while CAD software packages such as AutoCAD (Autodesk, Inc.) are available for micro-computers such as an IBM AT computer running a DOS operating system on an Intel 80286 microprocessor and 80287 math coprocessor.

The master engineering definition is created in 3-D graphics such that it includes appropriate coordination of the engineering design in a 3-D coordinate system. This design definition could be as a wire model or could utilize solid surfaces to form a hidden surface type model. Or it could include both of these as would be included in the CAD design software package.

The data model is initialized by inputting the master engineering definition of the aircraft in the 3-D graphics program as a data set or data sets (and stored as a file or collection of related files or other like association) in a data base (or other like software) in the computer system. After input or uploading of the engineering definitions and any other information which forms a part of the data model, as is discussed below, copies of the totality of the data model or portions thereof as data sub sets can be downloaded (for instance, as individual files) from the mainframe library in an appropriate manner using, for instance, the above mentioned TSO software to download from the above mentioned computer system to further computer systems or data interfacing devices.

Once the data model is established, it can be interfaced either through a human operator or through other software. For the purposes of describing the steps in interfacing with the data model, the interaction with the human operator (with the assistance of certain described software) will be described and then supplemented below where appropriate with respect to software emulating the steps performed by the operator.

A design engineer, programmer, or other operator using the data model or a portion of the data model and interacting with the computer system downloads the data model or a portion of it (normally by downloading files containing this data) and interacts with the data model or portion thereof with the use of the above noted operator interface means, i.e. light pens etc., at work stations 202-a to 202-c.

The operator selects a portion of the total structure, as for instance port side fuselage section 204 of Figure 4. In this figure these parts, as well as others, have been exploded from the workstation 202-a, 202-b and 202-c to show them in greater detail. In Figure 5 and other figures, select components are seen in greater detail on a screen 208-a to 208-g of the workstation 202-a to 202-c. From this major structural component, the operator taking advantage of the lofting lines and other design data in the data model selects a particular component part such as virtual skin panel 206.

Referring now to Figure 5, the loft lines of the virtual skin panel 206 in workstation screen 208-a suggest suitable profile cuts which can be used to define the skeleton for a virtual tool such as the virtual tool 156 of Figure 3 In workstation screen 208-a the individual loft lines each form a locus in a virtual surface 210 which includes the virtual skin panel 206. Using some of these loci (as for instance the ones traversing from the upper left to the lower right in workstation screen 208-b of Figure 5), or other lines, curves etc. the operator might create using the above noted operator interface means, the operator extends these loci in the surface 210 beyond the trim line of the virtual panel 206 and then away from the panel 206 in the direction of the interior of the virtual aircraft 154 and truncates them in a plane such that they form a plurality of virtual planes 212 which intersect or cut into the virtual surface 210.

Since the planes 212 define profile cuts, this has generated a series of virtual profile boards collectively identified by the numeral 214 of the virtual tool 156 of Figure 3. These virtual profile boards 214 define the virtual surface 210 which includes the virtual part 206. Referring back to the work station 202-b of Figure 4, the operator adds several virtual connector boards collectively identified by the numeral 216 to locate and orientate the profile boards 214. All of this is done using the 3-D interactive graphics software running on the computer system.

It is evident that the above steps are susceptible of being coded to create computer aided tooling design software. This software would utilize the computer system itself to create a tooling design. One such computer aided tooling design software is a program identified as TCAD (Tooling Computer Aided Design, Northrop Corporation).

Leaving certain details of the virtual tool 156 aside for the moment, the operator (or equivalent software such as the TCAD software) has now created the virtual tool 156. The graphics definition of the virtual tool is stored in computer memory as a part of the data model of the aircraft. Since the computer memory does not have any prejudice as to just what is or is not part of an aircraft, the tool design can become part of the data forming the data model of the aircraft 154. The portion of the data base containing the definition of the virtual tool 156 can be accessed and utilized for the manufacture of an actual tangible tool corresponding to the virtual tool 154. A data sub set (for instance as a file or files) of the data model data base can be created which would contain just the data defining the virtual tool 154.

Further reference will be made to Figures 4 and 5 below, however, prior to this further reference a description of certain physical or tangible (as opposed to virtual) components as seen in Figures 6, 7, 8 and 9 will facilitate the further understanding of certain processes shown in Figures 3, 4, and 5 and other figures. Additionally, the description of just how the individual components of a tangible tool are formed will also be facilitated if this is delayed until after the tangible tools themselves are described.

Figure 6 shows a tangible tool 218 equivalent to the bonding tool formation precursor tool 166 of Figure 3. While the tangible tool 218 and other tangible tools of Figures 9, 15 and 16 might at first appear to be very similar to the old "master tools", they are not.

The tangible tools of Figures 6, 7, 8 and 9 are not masters, they are working tools whose master exists in the data model in a data base in computer memory. They do not form the definition of a component; they are an expression of an already existing definition - the data model engineering definitions. As will be evident below, they can be reproduced if desired - they are not compromises of the engineering data as are the "master tools". They are precise expressions of the engineering definition of these tools. They can include explicit 3-D coordinate system locating points incorporated directly into their structure. They can include inherent surfaces of locator means which precisely position or locate each component piece with its respective neighbors as well as other attributes, as will be evident from this specification.

The tool 218 is composed of a plurality of profile boards 220, 222, 224, 226, 228, 230, 232 and 234. These "interact" with connector boards 236, 238, 240 and 242. Each of the profile boards 220, 222, 224, 226, 228, 230, 232 and 234 includes downwardly facing slots collectively identified by the numeral 244; one for each of the connector boards. Each of the connector boards 236, 238, 240 and 242 includes upwardly facing slots collectively identified by the numeral 246; one for each of the profile boards. Most of the slots 244 and 246 in Figure 6 have been covered and sealed with an aircraft sealant. However, each is as is shown in Figures 7 and 8.

The above referenced slots 244 and 246 are essentially "lap joints", albeit very special ones that, as will been seen, include an automatic rigging or positioning faculty. The depth of the slots in either the profile boards or the connector boards is of a depth allowing the profile boards to fit over and interlock with the connector boards with the bottom of the profile boards (as more fully described below) in contact and fitting against a supporting planar surface.

In Figure 7, to facilitate illustration, only one connector board, connector board 238, is illustrated. Further, only two profile boards, profile boards 220 and 232, are shown in Figure 7; and in Figure 8 only fragments of profile board 232 and connector board 238 are illustrated. As is seen in Figures 7 and 8, all of the slots in the connector board 238 face or open upwardly. Further, all of the slots in the profile boards 232 and 220 face or open downwardly. Because of this, the profile boards can be slid downwardly onto the connector boards.

To assemble the tangible tool 218 of Figure 6 all of the connector boards 236, 238, 240 and 242 are first set upright on a surface and then each of the profile boards, boards 220 to 234 respectively, are slid down one at a time over the connector boards with the slots 244 in the respective profile boards 220 to 234 respectively engaging the slots 246 of the respective connector boards 236 to 242.

A profile edge, collectively identified by numeral 248, on each of the respective profile boards 230 to 234, is precisely machined to exact specifications on an NC machining tool, as is hereinafter described. As opposed to the old "master models", the bottom surface (or portion thereof such as feet, collectively identified by the numeral 250 on all of the respective profile boards 220 to 234) is also machined to exact specifications. Because of this, if the feet 250 of each of the respective profile boards 220 to 234 are positioned in the same Z plane, the profile edges 248 are, therefore, also positioned with respect to that Z plane.

Each of the slots 244 on the respective profile boards 220 to 234 is machined to include a locator edge 252 and a non-locator edge 254. The locator edges 252 are machined in the profile boards to exact tolerances and orientations with respect to the profile edges 248 and the feet 250. The non-locator edge 254 is cut such that the slots 244 are wide enough to accept the thickness of the connector boards plus a non critical increment.

The same thing is done in machining the respective connector boards 236 to 242. Each of the slots 246 includes a locator edge 256 machined to exact specifications, and a non-locator edge 258 which is not critical but is spaced from the locator edge 256 an amount sufficient to allow the profile boards to fit into the slots 246 with a small amount of excess space.

A plurality of small wedges 260-A and 260-B are used to secure and also concurrently precisely locate the respective profile boards 220 to 234, and the respective connector boards 236 to 242, to one another to form a precision three dimensional structure. In Figure 8, the wedge 260-A is pushed between the non-locator edge 258 of the slot 246 on the connector board 238 and near face 262 of the profile board 232 to push far face 264 of profile board 232 tightly and accurately against the locator edge 256 of the slot 246 in the connector board 238.

In a similar manner, the wedge 260-B is pushed between the non-locator edge 254 on the profile board 232 and near face 266 of connector board 238 to push far face 268 of connector board 238 tightly and accurately against the locator edge 252 of the profile board 232. This is repeated for each of the intersections of a respective profile board 220 to 234 with one of the respective connector boards 236 to 242. When the profile boards and the connector boards are so assembled or automatically rigged into the tangible tool 218, it resembles an egg crate type structure. This assembled tangible tool 218 is an extremely precisely oriented and dimensioned structure.

Since the two end profile boards 220 and 234 are only held to the connector boards 236 to 242, respectively, by a single wedge (the bottommost wedge 260-B), in order to tightly hold these pieces against the respective locator edges on the respective connector boards 236 and 242, brackets, collectively identified by the numeral 270, are used to fixedly hold the end profile boards 220 and 234 to several of the connector boards. As for instance, connector boards 238 and 240. Brackets 270 would be attached to the respective profile boards 220 or 234 and the connector boards 238 and 240 after their position to one another was established by locating the profile boards 220 and 234 against the locator edges 256 on the connector boards 238 and 240, and the connector boards 238 and 240 against the locator edges 252 on the profile boards 220 and 234.

While more complex interaction between the respective profile boards and respective connector boards could be designed and constructed, for ease of both design and assembly, normally the locator edges 252 in the slots 244 in the profile boards would all be oriented the same way in space. As for instance, they would all be the far edges as viewed in Figures 6, 7 and 8. With the exception of locator edges 256 for one of the end profile broards (boards 220 or 234), the locator edges 256 in the slots 246 in the connector boards would all be oriented the same way in space. For example, they would all be the far edge as viewed in Figures 6, 7 and 8, except for the locator edges 256 on the connector boards which interact with the end profile board 234. The locator edges 256 for the profile board 234 would be on the near edge of the slots 246 in the respective connector boards 236 to 242.

The use of brackets 270, and the need to have one "odd" orientation of the locator edges 256 on the connector boards 234 to 242 for the end profile board 234, can be eliminated by simply extending at least one of the connector boards 236 to 242, respectively, slightly longer than the distance between the end profile boards 220 and 234 such that a "full" slot, as opposed to just one locator edge 256 (a half of a slot), is included on one or more of the connector boards 236 to 242, respectively. This full slot is then used to fix the end profile boards 220 and 234 to the connector boards.

Each of the respective profile boards 220 to 234 and the respective connector boards 236 to 242 includes a large vent hole, collectively identified by the numeral 272, to vent the structure when it is faired-in with plaster, as described below. In addition, the profile boards 220 to 234, respectively, each include a plurality of plaster support rod holes, collectively identified by the numeral 274. Plaster support rods, collectively identified by the number 276, are passed through the holes 274 and attached to the respective profile boards 220 to 234 with "Tinnerman nuts", collectively identified by numeral 278. The attachment of the plaster support rods 276 to the profile boards is not critical to the orientation or the precision of the tangible tool 218.

Referring now to Figure 9, wire mesh 280 is laid on top of the plaster support rods 276 and first a rough plaster 282 is laid over the mesh 280 and then a finish plaster 284 is faired-in using a fairing tool against the profile edges 248 on the respective profile boards. The plaster support rods 276, the mesh 280, and the two plaster plies are standard as per the plaster fairing of the old "master tool" concept.

After the plaster is faired-in, a transfer model 286, similar to the tool 172 of Figure 3, has been constructed. This transfer model 286 and its precursor tool 218 have been constructed on a grid table. However, as opposed to the old "master tool" concept, the support surface has not been incorporated as a part of the finished tool nor is it necessary to do this (however, as is shown in a further embodiment below, optionally a surface could be included but is can be formed as a light weight aluminum surface which does not need I beams, legs etc).

A further important point to note at this time is the orientation of the tools 218 to 286 in three dimensional space. They need not be constructed in "aircraft orientation". They are, in fact, constructed on a flat horizontal surface in a "horizontal" tool orientation that is very convenient for the assembler.

The flat horizontal surface used during assembly of the tool 218 of Figure 6 and its faired plastered counterpart tool 286 is the planar surface 288. This is shown in Figure 7 and in part in Figure 6. It need not be horizontally orientated in space except this is very convenient for the assembly personnel. The planar surface 288 is used during construction of the tools 218 and 286 but it does not physically become a permanent part of them.

The planar surface 288 is a flat plane which has been "Blanchard" ground such that it is very flat and contains a precision matrix of precisely sized holes, collectively identified by the numeral 290. The holes 290 are located in precise parallel lines: one set in the X axis and one set in the Y axis, to form a precision grid of squares each defined by four holes. Because of this, knowing the location of any two holes on the surface 288 in three dimensional space establishes a line on the surface 288 in three dimensional space and, knowing the location of any three holes on the surface 288 in three dimensional space, establishes the location of the plane of the surface 288 in three dimensional space. The holes, thus, serve as target means for defining a position in three dimensional space.

As will be noted in greater detail below, when the profile boards 220 to 234, respectively, (or even the connector boards 236 to 242 if desired) are designed and machined, coordinating points are established on at least one of the profile boards. These coordinating points could be a point where three edges meet. As for instance, at either of the corners of profile board 220 in the near foreground of Figure 6. Normally, they are chosen as explicit points which are placed at convenient locations on one or more of the profile boards.

Coordinating holes, collectively identified by the numeral 292, are shown machined into the profile board 220 of Figures 6 and 9, and the profile board 232 of Figures 6 and 8. These holes are sized to accept small precise target pins 295 shown in detail in Figure 19 which fit into them forming coordinating points with assigned X, Y, and z values on the profile boards. Similar target pins, albeit larger ones, target pins 294 (also shown in detail in Figure 18), are used in conjunction with the holes 290 in the surface 288.

A coordinating line 293 is located normal to the profile edge 248 of selected profile boards. This forms coordinating target values directly on the profile edge which becomes part of the faired plaster surface. Alternately, the coordinating points could be formed as crossed scribe lines. This would eliminate the need for target pins 295.

A computer aided theodolite system, such as the system 170 noted in the discussion of Figure 3, is used to establish a three dimensional coordinate system by establishing in three dimensional space the spatial positions of the holes 290 in the surface 288 using the target pins 294. Alternatively, the theodolite system 170 would establish the three dimensional coordinate system using the spatial position of a profile board (or connector board), such as profile board 220, via the coordinating holes 292 and target pins 295 or lines 293 or other precisely located points on the board. Once the surface 288 or the profile board 220 is established in three dimensional space the other can be coordinated in the three dimensional coordinate system with it.

The target pins 294 are formed as stepped cylinders having centered cross hairs scribed on their top surface. Related locator pins 297 are formed with a hemi-cylindrical upper section however their bottom section is identical to the pins 294 allowing them to also fit into surface grid holes such as holes 290 on surface 288. The locator pins 297 seen in Figures 6, 7, 8 and 19 are very useful during assembly of tools such as the tools 218 and 286 since the flat planar near or far faces 262 and 264 of the profile boards fit precisely against them and form a mating edge. The pins 297 can include a scribe line which is normal to that mating edge. Thus the scribe line serves as a first "cross hair" and the mating edge of a board serves as the other "cross hair". Because of this, the pins 297 can also serve as target pins.

Further by using the hemi-cylindrical locator pins 297, the edge of a board positioned against the locator pins 297 is directly centered over the center of a hole such as hole 290 in surface 288 and is held in this position. Thus the edge of the board is fixed in the X (or Y) plane with respect to the surface.

Since the surface 288 was established in three dimensional space using the pins 294 and a computer aided theodolite system such as system 170 and then a profile board, such as board 220 was established on the surface 288, the relationship of the surface 288 with respect to the board 288 is known. Now when the remainder of the tool 218 is assembled on the surface 288, the tool 218 now has been assembled in a known position in a three dimensional space coordinate system.

The surface 288 and the feet 250 on the profile boards 220 to 234, respectively, orientates the profile edges 248 in precise orientation in space with respect to the Z plane, and the locator edges 252 and 256 and the interaction of the tool 218 with the locator pins 297 fix the X and Y planes and precisely orient them with respect to hole grid on the surface 288. Thus, the locator edges 252 and 256 establish perpendicular X and Y planes, and the surface 288 adds the orthogonal Z plane.

After the tool 218 is established in three dimensional space, it is faired-in with plaster to form the tool 286. Since the tool 286 inherits the characteristics of the tool 218, tool 286 is also established with respect to three dimensional space.

The tool 286 is now used in conjunction with the surface 288 as a mold for a bonding tool. The pins 294 are positioned in the surface 288, and the bonding tool cast so as to include part of the surface 288 which contains these pins 294. The target pins 294 transfer as holes 296 in the bonding tool 298 of Figure 10. Since the holes 296 transferred to the bonding tool 298 will correspond to the target pins 294 which fit in the holes 290 in the surface 288, and since the holes 290 in the surface 288 were orientated to a three dimensional coordinate system, the bonding tool inherits this orientation in three dimensional space allowing the bonding tool 298 to be oriented with respect to the same three dimensional coordinate system in three dimensional space and to carry its own target coordinating points, the holes 296 created by the spatially known pins 294.

In describing the above tool 218 and its descendent tool 286, a number of connector boards 236 to 242 were utilized. Instead of using a plurality of connector boards, a single connector board could have been used if it was made sufficiently wide to provide for maintaining the respective profile boards 220 to 234 parallel to one another. For machining, economics, structural and material considerations, it is preferable to utilize a number of connector boards made from thin flat stock versus one made from wide stock.

In certain instances it might be desirable to include a base as a part of a tool transfer model, as for instance when the shape of the tool is very narrow. With a narrow tool the number of connector boards which can be used is limited simply because of space consideration. Taking into consideration the reasons as outlined in the previous paragraph, instead of using, for instance, one very wide bar stock connector board or a number of connector boards which are located very close to one another, a further embodiment of the invention shows the use of a limited number of thin flat connector boards (that is components machined from thin plate sheet versus heavy bar stock) plus a thin base board. This is shown in Figure 11.

In Figure 11 two bonding tool formation tools, completed tool 300 and incomplete tool 302, are seen. Both of the tools 300 and 302 are long and narrow. They are, in fact, tools for making a right side part and a left side part, i.e. mirror image configurations. Because they are long and narrow, as is seen with tool 302, only one central (or internal) connector board 304 is used.

Because only one internal connector board is used in the tools 300 and 302, the profile boards, collectively identified by the numeral 306 (only those of tool 300 being shown), extend or would extend when the tool 302 is finished, out beyond the back connector boards 308 and 310 of the tools 300 and 302, respectively, and also beyond the front connector board 312 of tool 302, and the unseen front connector board (not separately shown or numbered) for the tool 300.

By extending the profile boards 306 beyond the end connector boards, as discussed above, slots can be placed in the profile boards 306 for the back connector board 308 of tool 300; the back connector board 310 for the tool 302; the front connector board 312 for the tool 302; and the unseen front board for the tool 300. This adds to both the stability and to the precision of the tools 300 and 302 and other tools.

In the embodiment of Figure 11, the base 314 of tool 302 as well as the base 316 of tool 300 are initially positioned on the table surface 318. The table surface 318 is a duplicate of surfaces 164 and 288 discussed above. All of these surfaces 164, 288, or 318 could, in fact, be the exact same surface which is being used at a different time for a different tool. As with the other surfaces, 164 and 288, the surface 318 also includes a hole grid 320 in which locator pins 297 are being used to locate the bases 314 and 316 with respect to the surface 318. In locating the bases 314 or 316 to the surface 318 we are concurrently locating the tolls 302 and 300 constructed thereon relative to the surface 318.

Angle brackets 322 are used to first initially support the connector boards 304, 310, and 312 on the base 316. The profile boards are positioned on the connector boards 310, 304, and 312, and wedged together, as was described for the tool 218. The tool 302 is then fixed to the base 314 by securing the angle brackets 322 to the base 314. Alternatively, after the profile boards and connector boards are located in position with respect to one another using their respective locator edges, instead of utilizing the wedges to hold the structure together, the brackets 322, after being secured to the base 314, would serve this function. It is preferable however, to include the wedges.

Note that two separate tools 300 and 302 are being assembled simultaneously on a single surface 318. Both of the tools 300 and 302 can be moved from the table surface 318 when the assembly of these tools is complete. The table surface 318 is then free for the assembly of further tools. In the embodiment of Figures 6, 7, 8 and 9, the tool 286 can also be removed from the surface 288 after the bonding tool 298 is pulled from it.

It is evident that only one or, at most, only several of the surfaces 318 of Figure 11 and/or 288 of Figures 7 and 8, and/or 164 of Figure 3, are ever needed for the construction of many tools. Further depending on the size of the tools, several tools can be constructed on the same surface at the same time, This then requires only one (or a limited number depending on the production requirements) of Z planes , i.e. surfaces, for the production of a plurality of different and individual tools. In effect all of the different tools are normalized to the same Z plane and hole grid pattern located thereon.

In the top center of Figure 5 a representational machine tool 324 is seen forming a representational Z plane surface 326. This corresponds to the surfaces 164 and/or 288 and/or 318 or other standard surfaces which might be established. In effect, while a Z plane will be needed for each tool, it can be the same Z plane which is reused over and over again and need not be remanufactured, leveled, stored, etc., again and again for each different tool as is necessary with the old "master tool" way of manufacturing.

Just below the representational machine tool 324 in Figure 5 is a further representational machine tool 328 which is forming a plurality of parts, collectively identified by the numeral 330. These correspond to the individual unique parts of an individual unique tool such as those of tool 218. As can be seen in Figure 5 by the representational machine tools 324 and 328, and the parts they form, tools for use in constructing tangible surfaces which mimic the surface 210 in the workstation screen 208-b, can be constructed utilizing a standard component, surface 326, for one plane, the Z plane; and unique component parts 330, for definition in the other two planes, the X and Y planes.

In a family of tools each of which includes a Z plane, the standard component, surface 326, always gives at least one way of accessing back to the master engineering definition of the aircraft structure in the data model.

A workstation operator or appropriate software can normalize each of the members of a family of virtual tools which are being formed at the workstation screen 208-b (or in memory if software is being utilized) to the standard Z plane component by simply defining a Z plane shown by the representational arrows 332-332 in the lower left hand corner of Figure 5 associated with the virtual planes 212. This is easily done by an operator utilizing his light pen or other input device.

This Z plane 332-332 now creates a tool origin or configuration noted by the coordinates 334 which can (but does not necessary have to) differ from the aircraft origin or coordinates 336. If the tool coordinates 334 do differ from the aircraft coordinates 336, they are, however, both known to the graphics software and, thus, the data model and can always be referenced back to one another.

If a tangible tool, such as tool 172 in the upper right hand corner of Figure 5, which is located on surface 164, is being measured using tool coordinates by referencing coordinating points on either the tool 172 or the surface 164, since the tool coordinates in the data model (workstation screen 208-c) are known with respect to the aircraft coordinates (by matrix rotation or the like in the CAD software), the tangible tool is, therefore, also known with respect to the aircraft coordinates.

Referring again to Figure 4 and having seen representative tangible tools such as tool 218 and its faired plaster descendent, tool 286, to manufacture these tools, an operator or appropriate software such as the above referenced TCAD computer aided tool design program, selects the portion (normally a file or files) of the data set from the data model data base which defines the virtual tool 156 and brings this data set up into working memory. For illustrative purposes the data containing the definition of one of the virtual profile boards 214 is selected. The selected board 214 is individually identified as component 338. The component 338 is a virtual profile board and ultimately a tangible counterpart will be formed which will be one of the profile boards of a transfer model tool, as for instance tool 286.

As was described above in first designing a virtual tool, except where explicitly noted, the description of the formation of the tangible components will be addressed using an operator to carry out certain tasks. It is realized, of course, that whatever tasks the operator carries out, the same tasks would be coded into appropriate software instructions as functions, macros, procedures and, the like, in appropriate programs. These programs and supporting software such as appropriate AI (artificial intelligence) software would be utilized in place of the operator directed task.

Most specifically, the following noted operations might also be accomplished using the above referenced TCAD computer aided tooling design software plus computer aided tooling manufacturing software such as TCAM (Tooling Computer-Aided Manufacturing, Northrop Corporation). These can be augmented, as can the operator directed operations as described below, with the above mentioned CADAM and with MAXCAM (Multi-Axis Computer-Aided Manufacturing, Northrop Corporation) and the above mentioned NCAD.

MAXCAM is an interactive graphics numerical control programming system which utilizes an interactive graphics terminal to develop, simulate and submit a machine program to an APT processor. A MAXCAM standard tool library is maintained in a logical and hierarchical manner in a data base. As for instance, the IBM DB2 data base management tool (IBM Corporation) that allows for ad hoc queries and rapid report utilizing tables of attributes pertinent to items like feed rates, speeds, etc.

A data set from the data model data base containing the component 338 is loaded into working memory and onto the workstation screen 208-D in Figure 4-b. The profile edge 340 has already been defined. It was defined by the intersection of virtual planes 212 (corresponding to the virtual profile boards 214 of the virtual tool 156 of Figure 4-a) with the virtual surface 210 (see workstation screen 208-b of Figure 5). The virtual surface 210 in turn included the virtual part 206 from the virtual aircraft 154. The bottom edge 342 also has already been defined by cutting with a plane as per the Z plane 332-332 of Figure 5 described.

Since we are dealing with a virtual image of a part of the virtual tool 156 which in reality is only a set of mathematical algorithms defined within the 3-D graphics software, all lines of this image have no thickness. The lines of this image only divide space. The intersect lines 344, 346 and 348 of the virtual connector boards 216 of the virtual tool 156 are, thus, only lines on a virtual component which divide space. So also are the profile and bottom edges 340 and 342. Because of this, they define precise lines (curves, arc, etc.) which are known with absolute precision in the coordinate system of the 3-D graphics software.

While the profile edge 340 and bottom edge 344 define outside boundaries, the intersect lines 344, 346 and 348 do not - they define where one tangible component will interface with another. At this point in time the intersect lines 344, 346 and 348 do not yet have thickness corresponding to the thickness of these respectively tangible components. In view of this, they can be used to define the virtual counterparts of the locator edges 252 on corresponding tangible profile boards.

To define the remainder of a slot in which a connector board will fit, the operator working with his or her light pen or other interface device, and having decided, for instance, that all of the locator edges will be on the left hand side of all slots in the profile boards, defines the slot 350 which contains the locator edge 344 by moving the light pen to trace this slot to the right of the intersect line 344. This defines the slot 350 and leaves the intersect line 344 as the locator edge in that slot. Since the intersect line 344 is precisely known in the coordinate system of the graphics software, the locator edge it now defines will also be precisely known.

This is repeated for the remaining slots 352 and 354. They too will include the precise orientation and location of their locator edges because of their respective intersect lines 346 and 348. The operator removes some of the bottom edge 342 to define virtual feet, collectively identified by the numeral 356. The operator then goes on to added target points, collectively identified by the numeral 358. The virtual part is nearly finished except for vent holes and the plaster support rod holes. The position of the plaster support rod holes will be defined in the same manner as were the virtual connector boards 216 by adding lines which intersect the virtual profile boards 214 of the virtual tool 156 at points. With the virtual component part 338 at the workstation screen 208-d, the points defined in the virtual part 156 are expanded to holes, and the vent holes are added by the operator at designated locations.

At this point in time, the virtual component 338 on the workstation screen 208-D of Figure 4 has been modified into a complete virtual profile board 360 shown in the workstation screen 208-E of Figure 12-a. The virtual profile board 360 is saved in the data base and becomes a component part of the data set forming the data model.

Figures 12-a to 12-c show the formation of a tangible part from the memory definition of the same in a data base by using further improvements of this invention. Using interactive 3-D graphics, the operator loads the data set (the file) containing the virtual profile board 360 onto the workstation screen 208-F of Figure 12-b. The operator also loads, as is shown on workstation screen 208-F, an interactive graphics numerical control programming system depicted as the indicia 362 on the screen 208-F. One such interactive graphics programming system is above referenced MAXCAM which interfaces with an operator utilizing menus which describe "tool macros". In a further improvement of the invention, the above referenced TCAM software would be used to further limit the amount of operator interfacing.

Having logged on with the interactive graphics loaded at the workstation, the workstation screen 208-F presents the operator with a choice of various tool macros. Each of these tool macros defines an automated machining operation. Some of the macros describe non-machining processes such as cooling on, cooling off, tool change, etc. Others describe machining operations such as face mill, drill, rough and finish pocket, rough and finish profile, regional mill, or flange top. Machine operator instructors can also be entered with appropriate details for the machinist, as can instructions for the formation of 2-D plan drawings for the machinist's use if necessary, depending on the ultimate machine which will be used to form the component part.

The operator first selects planning macros which interface with the NC machine library of the system. The necessary planning information to be utilized by other macros, such as part information including material type and condition, is entered; next, machine tool characteristics, such as number of axes and spindles, bed size, part orientation or maximum X, Y, and Z travel is also entered. Further fixture information like number of stages, tool design information, and clamp types and location are entered.

After the planning is entered, the stage design is entered. The operator can enter routines to develop multiple stage fixtures, fixture definition, tooling tabs, etc. Once the staging is completed, cut programming begins by selecting the cut macros (drill, ream, etc.) for the geometry and, as these are entered, the cutter and its parameters (speed, feed, etc.) are defined.

The geometry of the cut is picked and the macro is executed. The operator can then simulate the cutter movements through visual representation, as is shown on the workstation screen 208-F in Figure 12 showing the operator the "on the fly" cutter paths to produce the tangible component corresponding to the virtual profile board 360. Once the total part formation or manufacturing operation is complete, it is saved for future reference as part of the data model. Further saves can also be made to update the MAXCAM tooling library.

If an NC machine which requires a tape for its input instruction will be utilized to produce the component part, an NC cutter tap 364 is now generated. Alternately, the cutter information is directly downloaded via a data bus 366 to a digitally controlled machine tool (a computer numerical controlled tool) which resides in the software post processor file, or to an interface medium such as floppy disk 368 for indirect transfer to such a digitally controlled tool. Transfer to a digitally controlled tool can also be through a further computer system such as a micro or mini-computer.

The tape 364 or disk 368 or direct bus 366 computer control is then utilized to run an appropriate tool means such as NC machine tool 370 to cut a tangible profile board 372 from suitable feed stock 374. Aside from numerically controlled machine tools, such as tool 370, the component formation information (tape 364, disk 368 or direct downloading of a memory copy of an instruction via a data bus 366) can be used to direct component part formation by other tools, such as numerically controlled laser cutters, numerically controlled assembly robots, computer numerically controlled machine tools, computer numerically controlled laser cutter and computer numerically controlled assembly robots.

Not only does the tool 370 cut the outside profile, slots and locator edges, plaster rod holes, and vent holes of the tangible part 372, it also forms the coordinating target points (holes, cross scribe lines, etc.) directly on the tangible component part 372. This, then, places a direct reference on the component part 372 for location in a know precise position and orientation in 3-D space for referencing and locating the part 372 to other components, tools, parts, etc. residing in the data model for the aircraft structure.

It is evident that once the definition of the component part 372 and its formation instructions are created in the data model in computer memory, because this is retained as the "master instruction" for the particular part, an exact duplicate can be formed by simply making a further call to these instructions and feeding this further call to an appropriate forming machine to recreate an exact duplicate of the part. This is also true of every other component which makes up a part of the data model and is stored in the data base defining the data model design, and manufacturing instruction for the complete structure.

In using the data model, if component parts for tooling, assembly, etc., for a first aircraft were produced and a first aircraft was built, all of these first physical components could be scrapped and identical ones could be produced from the data model and a second aircraft built using them. The second aircraft would essentially be a duplicate of the first. This is not true with the "master tooling" concept since each aircraft would incorporate all deviation of its "master tool," from the engineering specifications.

Again referencing Figure 5, the operator can call up a further copy of the file of the virtual part 206 and/or the virtual surface 210 derived from the virtual surface 206 from the data model and load it on a workstation screen 208-G. As described before, the operator utilizes this virtual surface 210 to form a tool (as for instance, virtual tool 156) which included and, therefore, mimicked the surface 210 (an image copy of it). Instead of making an image copy tool, a complementary image tool can also be formed.

Building up from the surface 210 on the workstation screen 208-G, the operator defines a virtual assembly jig 376 on the virtual surface 210. When a tangible component is formed which corresponds to this virtual assembly jig 376, it will be complementary to the surface of the actual tangible part such that the surface of the actual tangible part can be positioned against the assembly jig and a required assembly operation performed on the actual tangible part in conjunction with the assembly jig.

Typically, such assembly jigs would be used to locate parts during drilling, bonding, or joining and the like, where one part is prepared for assembly to an adjacent part or is fixed in position during actual assembly of these adjacent parts.

During the design of the virtual assembly jig 376 on the workstation, appropriate target points can be added to the assembly jig such as the virtual target points, collectively identified by the numeral 378. Since these target points 378 will become part of the data set defining the virtual assembly jig 376 in the data model of the aircraft, when a tangible assembly jig corresponding to the virtual assembly jig 376 is formed, tangible target points will be known on the tangible assembly jig. These tangible target points will, therefore, be known a in precise relationship with the part which will correspond to the virtual surface 210, and they will also be known with respect to the total structure of an aircraft corresponding to the virtual aircraft 154.

In addition to the virtual assembly jig 376 which is designed in the 3-D graphics, a virtual gantry structure 380 i.e. an assembly structure rough structure, can also be designed at the workstation 208-G. This gantry positions and holds the virtual assembly jig 376 in space. Appropriate locators or coordinating points, collectively identified by the numeral 382, can also be included on the virtual gantry 380. When an actual tangible gantry corresponding to the virtual gantry 380 is constructed, tangible aircraft parts being assembled, drilled or the like in conjunctios with the tangible assembly jig corresponding to the virtual assembly jig 376 can be positioned in space with respect to the tangible gantry by utilizing these locators or coordinating points.

As with the above described tool 218 and its descendent tool, tool 286, the data sets (files or the like) in the data model data base containing the definitions of the virtual assembly jig 376 and virtual gantry 380 can be downloaded to appropriate NC tools or machine centers for forming the actual tangible assembly jigs and gantries.

Figure 13 shows an assembly jig 384 which corresponds to the virtual assembly jig 376. It is supported on a gantry 386 which corresponds to virtual gantry 380. Target points 388 have been located on the assembly jig 376. These correspond to the virtual target or coordinating points 378 in the file for the virtual assembly jig 376 in the data model. Located on the gantry 386 are locators 390 which correspond to the virtual locators or coordinating points 382 for the virtual gantry 380 in the data model.

Also shown in Figure 13 are further assembly jigs 392 and 394. These are also supported by the gantry 386. They would also include appropriate target points for precisely locating them on the gantry with respect to one another. Note assembly jig 392 contains a drill pattern 395 which would also be laid out with precision on a virtual counterpart. Once on the assembly bay floor, other common assembly components such as worker scaffolding 396 is also associated with the gantry 386.

As noted above, in using the "master tool" concept, the assembly jigs had to be rigged with the gauging master and locators positioned. The gauging master was removed and the locators repositioned on the rough structure. Not only did this introduce problems with respect to the re-positioning of the locators but it meant that the assembly jigs normally had to be in "aircraft orientation" since that is how the majority of the gauging masters were oriented.

With the present invention, the assembly jigs can be positioned in whatever orientation it is convenient to use. This can vary from actual "aircraft orientation" to 90° rotation, or even completely rotated 180° out of phase or any other orientation. Thus, in an assembly situation such as that of Figure 13, the actual part might be located in an upside down position or at some angle. Thus, if desirable for assembly personnel or assembly robots to work in something other than "aircraft orientation", because all parts, whether they be actual aircraft parts or assembly jigs and the like, can be absolutely referenced back to "aircraft orientation" via the data model and its associated data base, any assembly orientation can be chosen.

Figure 13 shows a further view of the computer aided theodolite system 170 of Figure 3. Shown in Figure 13 is a commercial computer aided theodolite system 398, a Wild C.A.T., 2000 Coordinate Analyzing Theodolite System sold by Wild^{•} Heerbrugg, Farmingdale, NY. The C.A.T. 2000 System utilizes either Wild T2000 or T220S theodolites, a Hewlett-Packard Series 200 Computer, a Hewlett-Packard Thinkjet Printer and runs Wild C.A.T. 2000 series software, part #900598, licensed from the Boeing Corporation. Attached as appendix A are copies of an operator manual, a literature brochure and a reference manual for the C.A.T. 2000 System, the entire contents of which are herein incorporated by reference.

The theodolite system 398 has several operational modes including job setup, measure, build and inspect which are menu driven. After set up, wherein the computer 400 is turned on and the first and second theodolites, collectively identified by the numeral 402, of the system are calibrated, leveled, collimated etc., an appropriate coordinate system can be entered and stored. The theodolites 402 of the system then measure azimuth and elevation angles of selected points in space and send this information to the computer 400. The computer software converts this angular data to X, Y, Z coordinates relative to the currently established coordinate system. The software can also manipulate this data to provide other information pertinent to the measurement.

In a build mode, the theodolite system 398 allows coordinates of a location to be entered. The theodolites 402 are then redirected until they point to that position in space. A part can now be located with respect to that position. In the inspection mode, the system 398 indicates the deviation of the positions the theodolites 402 are pointing to from a previously indicated set of coordinates.

By following the above teachings of this invention, target or coordinating points for each component of a structure, a tool associated with that structure or an assembly tool utilized in conjunction with that structure, are known in the file or files of the data model and are also known with respect to the engineering definition of the structure within the data model. During construction or formation of these component parts etc., these target or coordinating points can be "downloaded" to and incorporated directly on the components or associated structures by forming tangible targets or coordinating points as an integral part of each component, or group of components, or associated structure.

The theodolite system 398 can be used to verify the relationship of one component to another by using these known coordinating points, or it can be used to position one component or associated structure with respect to a further component or further associated structure.

Thus in Figure 13, target points 388 on the assembly jig 384 can be used to locate a component part with respect to the assembly jig 384, or to locate the assembly jig 384 with respect to the gantry 386 or the other assembly jigs 392 or 394. Further in Figure 13, set in the assembly bay or cell are targets, collectively identified by the numeral 404. For illustrative purposes, these are shown permanently reset into the assembly bay floor in a precisely known relationship with one another in a manner equivalent to the grids system on surfaces such as surface 288. They, thus, can serve as known coordinating points for any structure or structures which are assembled in that assembly bay. Alternately to setting the target 404 in the assembly cell floor, the targets 404 could be associated with other structure within the assembly cell such as the walls, ceiling or the like.

The theodolite system 398 can reference these targets 404 to establish a known coordinate system. This coordinate system can then be used as a "yard stick" for referencing back to the coordinates of the engineering definition such that anything in the data model data base can be referenced in 3-D space with anything associated with the coordinate targets 404.

As opposed to the use of gauging masters, in the structure of Figure 13, the position of the locators 390 can be verified by using the theodolite system 398 and the data in the data model which defines the location of the locators 390. Thus, if desired, in between each assembly operation conducted at the assembly cell, the locators 390 can quickly be audited with the theodolite system 398. This can be done in tens of minutes compared to the several days which are required when using gauging masters.

Further, since everything with respect to the manufacture of an aircraft is referenced directly back to the data model and no gauging masters are needed, the formation of the component parts and the construction of the gantry 386 and its associated assembly jigs 384, 392 and 394 can be started immediately upon completion of the design phase of the aircraft and does not have to wait for the formation and construction of other components. The formation and construction of these components can be done in parallel with other components such as the above described bonding tool 296.

In an analogous manner to the assembly jigs 384, the gantry 386 and their targets 388 and locators 390 and the assembly cell targets 404, in Figure 14, an assembly floor is also equipped with targets, collectively identified by the numeral 406, permanently recessed therein. These can be used with a computer aided theodolite system 408 which has been permanently installed on the assembly floor. Since all component parts of the aircraft can include appropriate coordinating points thereon, the theodolite system 408 can reference coordinating points on component parts of a fuselage section 410 of an aircraft being assembled. The coordinating points can then be referenced back to the data of the data model in the data base file to the coordinating points of an aft section 412 of the aircraft. This can be used to precisely position the aft section 412 to the fuselage section 410.

In Figure 15, a tool 414 is shown during assembly on a table 416. for illustration purposes, the near half of the tool 414 has been faired-in with plaster while the far end has been left open. Further, target pins 294 have been positioned in some of the holes of the table 416. This incompletely finished tool is useful for showing several aspects of the invention.

The theodolite system 398 can reference the target pins 294 to establish the plane of the table 416 in its memory. This can then be used to coordinate any thing associated with the table 416 with the data model definitions in its data base. Alternately, target points or coordinating points 418, 420 and 422 on profile board 424, can be used to establish a plane and to coordinate with the data model since by the above described method of formation of the profile board, these target points are also precisely known. In any event, whichever of the table 416 or the profile board 424 is used to set the coordinate system, the other can be referenced to it.

In addition to the use of the above described locator edges 252 and 256 to establish the precise positioning of profile boards to connector boards, the theodolite system 398 can also be used to check the location of each of the remaining profile boards, collectively identified by the numeral 426, one at a time as they are loaded onto the connector boards, or as a group when the assembly is finished.

In the same manner, the theodolite system 398 can be used to verify the surface profile of the faired-in section 428 of the tool 414. After plaster fairing, the surface profile of the section 428 of tool 414 is an exact image of an actual portion of the surface of an aircraft. Since utilizing the data model, a file copy from the data model data base containing the engineering definition of an aircraft part can be downloaded as for instance via a floppy disk and can be uploaded into the theodolite system 398, any point on the surface of the section 428 can be compared to its virtual image in the data model.

Any deviation which might have been introduced by inappropriate assembly or fairing can be corrected to the engineering specification of the master design definition prior to perpetuation of any such deviation to actual production components. If the plaster fairing is high or low, it can be shaved or filled in as required.

In Figure 16, the remainder of the plaster has been faired on to the tool 414 of Figure 15 to form completed tool 430, and a complementary bonding tool 432 cast on the tool 430. The near part of the bonding tool 432 is broken away to show the tool 430 as well as certain of the target pins 294 on the table 416.

In the manner described above, by casting the bonding tool 432 over both the tool 430, as well as portions of the table 416 including the target pins 294, the bonding tool 432 not only forms a complementary image of the tool 430 but also incorporates the hole grid 434 on the table 416 because the target pins 294 form target holes 436 in the bonding tool 432 which correspond precisely to the hole grid 434 of the table 416.

Just as the theodolite system 398 can audit the surface of the tool 430 and reference back to the data model, so can the theodolite system 398 audit the complementary surface 438 of the bonding tool 432. As with the lines 344, 346 and 348 (Figure 4-b) discussed above, since a virtual surface, such as virtual surface 210, of the aircraft structure in the engineering definition in the data model data base is only a virtual mathematical surface which divides space and has no thickness, we can look at it from the outside like we do when we compare the surface of the tool 430 to the master design definition. However, we can also look at it from the inside and compare the complementary image of that surface on the bonding tool 432.

Referring back to the bonding tool 298 of Figure 10, as noted, it included holes 296. These were "picked up" when the bonding tool 298 was pulled from both the tool 286 and the surface 288 which included target pins 294. This inside surface 440 of the bonding tool 298 is a complementary surface, but the data model definition does not care if we look at it from the outside in or the inside out. Thus, the inside surface 440 of the bonding tool 298 can be referenced back to its virtual counterpart in the data model data base file. Its virtual counterpart, of course, being the virtual surface 210. This surface 210 is the same, irrespective of whether in human terms it is looked at from the outside in or the inside out.

The holes 296 picked up from the surface 288 allow coordination of the inside surface of the bonding tool 298 back to the virtual tool 156 in the data model and from there to the virtual surface 210, which the bonding tool 298 is a tangible complementary mimic thereof.

Using the theodolite system 398, the known value holes 296 from the target pins 294 in the surface 288 allow for the precise placement and coordination of further precisely known target points 442 onto the inside surface 440 of the bonding tool 298. Coordinate points on the virtual surface 210 can be picked up and downloaded to the theodolite system 398 and then the theodolite system 398 placed in build mode and the theodolites 402 sighted. Reference points for the targets 442 are made by scribing, drilling and the like at the points on the inside surface 440 of the bonding tool 298 at which the theodolites are pointing.

Alternately, a theodolite equipped with a laser can be used to locate appropriate target points on any of the surfaces described. Having established the targets 442 on the inside surface of the bonding tool 298, when a composite skin panel 444 is formed against the inside surface 440 in Figure 17-a, the targets 442 are used to precisely locate the longeron 446 and spars 448 against the skin panel 444.

The bonding tool 298 (or 432 or 176) allows for direct assembly of the supporting structures (longer ones 446 and spars or stiffeners 448) onto a composite skin panel 444. It can also serve as the support structure during curing of these components in an autoclave. By forming the bonding tool 298 of calcium oxide, calcium sulfate, or combinations of these two calcium slats as a matrix material, and by incorporating layers of structural fibers in this matrix, an easily constructed, inexpensive, but highly accurate and autoclaveable bonding tool is achieved.

Suitable for the calcium oxide or calcium sulfate are Ultracal™ 30 or Ultracal™ 60 manufactured by United States Gypsum Company. Suitable as the structural fibers are layers of fiberglass mat. It has been found that fiberglass mats manufactured for use with polyester resins form a very good interface with the above noted Ultracal™ products if layered in the Ultracal™ product. Normally, several layers would be utilized. As for instance, 20 to 30 such layers.

The resulting bonding tools, as for instance bonding tool 298, are then used to support the skin panel 444, the longerones 446, and spars 448, during curing to form a finished component 450 which meets the engineering definition for that part as defined in the data base file of the data model. As so constructed, the bonding tool 298 can be used or cycled repeatedly for the forming and curing of identical parts. At any time, an audit can be made of the bonding tool 298 to verify that it still defines the proper surface parameters. Since such as audit is referenced directly back to the data model via the theodolites system 398 and not through a check tool, there is never any question whether or not the bonding tool 298 still meets the engineering specifications for the part formed on it.

Figure 18 is a flow sheet of certain processes of the invention. These processes are initiated by logging on at 451 in an appropriate computer system and creating a file for the data model 452. Once in the data model 452, the engineering definition 454 of the aircraft structure is entered. A component portion of that engineering definition 454 is then selected and a component or surface definition 456 is created.

The data sub set defining the surface portion 456 can then be further processed by either one of two branches which diverge at junction 458. First following the left hand branch, a tool definition 460 is created by an operator interacting with appropriate data from the data model 452 utilizing appropriate 3-D graphics software. Having created the tool definition 460, next tool manufacturing processing steps 462 are defined. Again, this is done by the operator in conjunction with software assistance, as for instance the above noted MAXCAM software.

Once the tool definition 460 is complete, and its manufacturing processing steps 462 are completed, the manufacturing processing steps 462 are downloaded to appropriate tooling means 464 to make the component tool parts.

The tool definition 460 can be fed back or uploaded to the data model 452 to become an inherent adjunct part of the data model 452. Additionally, the steps outlining the manufacturing processing steps 462 for the tool can also be fed back to the data model 452 and become an inherent part of it. Having been added to the data model 452, both of these additions to the data model 452 can now be accessed as component parts of the data model 452.

Referring now to the right hand branch leading from the junction 458, a tool can be auto defined by appropriate software, such as the above mentioned TCAD to create an auto tool definition 465. This auto tool definition 465 is then downloaded to further automated manufacturing software which defines automated manufacturing processing steps 466 for the formation of a tool. The automated manufacturing software would include software such as the above mentioned TCAD in conjunction with TCAM and MAXCAM.

Once the automated manufacturing processing steps 466 are created, they are downloaded to automatic tool producing machinery represented by auto tooling means 468. The component parts of the tool are formed by the auto tooling means 468. As with the left hand operator branch of Figure 19, the right hand automated branch of Figure 19 can also feed back or upload back to the data model 452 via the connector A-A. Thus, both the auto tool definition 464 and the automated manufacturing process steps 466 can be fed back to the data model 452 to become an inherent part of the data model 452.

Anything in the data model 452 can be downloaded to a theodolite system 470 for comparison of components. Thus, if desired, the tool parts, either via the operator branch to the left of Figure 19 or the automated branch to the right of Figure 19, can be compared at junction 472 with appropriate coordinates which have been downloaded into the theodolite 470 from the data model 452. At the comparison at junction 472, feedback can once again be made to the data model 452 to update the data model 452 as to the actual physical parameters of the tool components.

The tool components are then assembled at assembly process step 474, and again, if desired, a comparison can be made at the junction 476 utilizing the theodolite system 470. Once again feedback can be made back to the data model 452 for input of the actual parameters of the assembled tool to the data model 452.

From the assembled tool a component part of the aircraft is made at process 478. If desired, the theodolite system 470 can again be utilized to check this component part to anything in the data model 452 at junction 480. Again, the actual physical parameter of the completed part can be uploaded back to the data model 452 to become an inherent component part of the data model 452. The parts produced are then assembled into the final aircraft structure at assembly step 482, and the totality of the aircraft structure can again be checked at junction 484 with input from the theodolite system 470. Again, the actual parameters of the completed aircraft structure can be uploaded back to the data model 452 to become an inherent component of the data model 452.

At all points during the manufacturing of tooling, the formation of component parts, or the final assembly, any parameters determined from previous parts or steps, having been fed back and made an integral part of the data model 452, can be downloaded to the theodolite system 470 to audit further parts, tools, assemblies, etc., at later steps.

As the manufacturer of the aircraft proceeds from the original definition, an engineering definition at 454, to the final assembly, a complete history of all component parts, tools, etc., which have gone into the assembled aircraft, can be measured against their engineering definitions, and any deviation thereof can be stored as part of the data model 452 and downloaded to the theodolite system 470 as input to be used during auditing of later manufacturing steps.

By constant update of the data model 452, an archive of all information known with respect to any intermediate component, part, tool, assembly, etc., or the final assembled aircraft, can be associated together and downloaded where appropriate for other manufacturing steps. Any and all of the individual theodolite audits of tools, parts, or assembly audits, may or may not be made depending upon the necessity or desirability of an audit at that point.

This invention utilizes certain principles and/or concepts as are set forth in the claims appended hereto. Those skilled in the manufacturing arts will realize that these principles and/or concepts are capable of being utilized in a variety of embodiments which may differ from the exact embodiments which are utilised for illustrative purposes herein. For this reason, this invention is not to be construed as being limited solely to the illustrative embodiments but should only be construed in view of the claims.

## Claims

1. A method for manufacturing a multi-component article of manufacture which method comprises:
- generating a definition of said article including definitions of component parts of said article, as a graphics data set in a data base in a 3-dimensional graphic computer system, said definition including coordinate points precisely locating said definition of said article and said component parts in a 3-dimensional coordinate system, a definition of at least one forming tool means for forming component parts of said article and a definition of an assembly tool means for assembling component parts of said article;
- selecting at least a portion of said definitions of said article, said forming tool means and said assembly tool means, respectively;
- generating a further graphics data set by defining virtual images of at least one of said forming tool means and at least one of said assembly tool means, said virtual images of said forming tool means and said assembly tool means including said coordinate points;
- downloading said definitions of said forming tool means, said assembly tool means and said further data set from the memory of said computer to means for making tools;
- operating said means for making tools with said data and further data set as input to said means for making tools to form at least portions of said forming tool means and said assembly tool means and to locate coordinating points on said portion of said forming tool means and said assembly tool means;
- forming with said forming tool means at least a portion of the component part of said article corresponding to said selected portion of said definition of said article; and
- assembling said component part of said article with said assembly tool means, to eventually manufacture said multi-component article of manufacture, whereby said coordinating points on said forming tool means and said assembly tool means are referenced to corresponding points on said component part of said article by means of the coordinate points included in the definition of said article.

2. The method of manufacturing an article of claim 1 including:
operatively associating with said computer system a microprocessor controlled measuring means for measuring objects in 3-dimensional space; and
operating said measuring means to measure points on said component parts of said article to compare said component parts with said definition of said article.

3. The method of manufacturing an article of claim 2 including:
selecting a microprocessor controlled theodolite system as said microprocessor controlled measuring device.

4. The method of manufacturing an article of claim 1 wherein:
said means for making said forming tool means further includes computer assisted tooling design software means for defining a sequence of machine operations for machining tooling parts and computer assisted tooling manufacturing software means for inputting said sequence of operations for machining tooling parts to a machine tool whereby said machine tool machines component forming tool parts.

5. The method of manufacturing an article of claim 1 including:
associating an output means with said computer system, said output means for outputting copies of data sets in said data base in said computer system;
downloading said further data set to said output device to form a copy of said further data set;
inputting said copy of said further data set to a microprocessor controlled optical measuring means, said measuring means for measuring objects in 3-dimensional space; and
operating said optical measuring means to measure said coordinating points on said forming tool means and said assembly tool means to compare said forming tool means and said assembly tool means with said virtual images of said forming tool means and said assembly tool means in said data set.

6. The method of manufacturing an article of claim 1 further including:
selecting said means for making tools from one of a set of tools consisting of numerically controlled machine tools, numerically controlled laser cutters, numerically controlled robots, computer numerically controlled machine tools, computer numerically controlled laser cutters and computer numerically controlled robots.

7. The method of manufacturing an article of claim 1 wherein:
said forming tool means includes a tool having a plurality of profile boards, at least one connector board, said profile boards including at least one profile edge, said profile edge of each of said profile boards located in a moldline surface which defines an image of said component part of said article, each of said profile boards further including locator means for fixedly locating said profile board with respect to said connector board, said connector board further including locator means for fixedly locating said connector board with respect to each of said profile boards, said respective locator means each including a locator edge on said respective profile boards and said respective connector board.

8. The method of manufacturing an article of claim 1 wherein:
said forming tool means includes mold means for forming component parts of said article;
said mold means including: a surface; a plurality of target means for defining a precisely known spatial relationship in a 3-dimensional coordinate system, said plurality of target means located on said surface for defining precisely known positions on said surface; an image mold, said image mold including an image of a component part of said article, said image mold locatable on said surface in a known association with said spatial means; and a complementary mold formed on said image mold and said surface, said complementary mold including a complementary image of said article component part and further including an image of said spatial means on said surface; and
said image of said target means on said complimentary mold defining precisely known positions on said complementary mold which are precisely located with respect to said complementary image of said article component part on said complementary mold to precisely define said complementary image of said part with respect to said 3-dimensional coordinate system whereby when an article part is molded on said complementary mold, points on said part are precisely known with respect to said 3-dimensional coordinate system.

9. A multi-component article manufacturing system which comprises:
- a 3-dimensional graphics computer system containing a graphical data model of an article in a data base in said computer system, said article including a plurality of component parts;
- said computer system including means for defining a graphical virtual surface in said data model of said article as one of said component parts;
- said computer system including means for defining a graphical virtual member in said data model of said article, said virtual member including at least a portion of said graphical virtual surface;
- said computer system including means for defining at least one forming tool means for forming component parts of said article as a further graphical virtual member;
- said computer system including means for defining an assembly tool means for assembling component parts of said article as a further graphical virtual member;
the system further including:
- means for forming a tangible member which corresponds to a certain of said graphical virtual members, said means for forming a tangible member operatively interfaced with said computer system;
- means operatively associated with said computer system for downloading said definition of said graphical virtual member in said data model to said means for forming a tangible member whereby said later means forms a tangible member corresponding to said graphical virtual member;
- means for assembling said tangible members to form said article, whereby the spatial relationships of the tangible members corresponding to said graphical virtual members of said article, said forming tool means and said assembly tool means are referenced to each other by means of coordinating points on said tangible members corresponding to coordinate points in said graphical virtual member definitions.

10. An article manufacturing system of claim 9 further including:
a microprocessor controlled measuring means for measuring points on said tangible member and to compare said measure points to said definition of said article in said computer data base.

11. An article manufacturing system of claim 9 whereby
said tangible member forming means comprises an image tool means for forming one of an image copy or a complementary image copy of at least a portion of said article.

12. An article manufacturing system of claim 9 wherein:
said respective means for defining said graphical virtual surface and for defining said graphical virtual member includes an operator interface means for inputting commands to said computer system, said operator interface means operatively associated with said computer system.

13. An article manufacturing system of claim 9 wherein:
said respective means for defining said graphical virtual surface and for defining said graphical virtual member includes computer assisted tooling design software means for defining a sequence of machine operations for machining a tangible part; and
said means for forming a tangible member includes computer assisted tooling manufacturing software means for inputting said sequence of machine operations to a tool means whereby said tool means forms a tangible part which is a mimic of said graphical virtual member in said data model of said article.

14. An article manufacturing system of claim 9 wherein:
said means for forming a tangible member includes at least one numerically controlled tool means for forming a part and where said numerically controlled tool means is selected from tool means consisting of numerically controlled machine tools, numerically controlled laser cutters, numerically controlled robots, computer numerically controlled machine tools, computer numerically controlled laser cutters and computer numerically controlled robots.

15. An article manufacturing system of claim 9 wherein:
said data model of said article includes coordinate points for precisely locating a design definition of said article in a 3-dimensional coordinate system; and
said means for downloading said definition of said virtual member in said data model includes means for including coordinate points on said virtual member precisely locating said virtual member in said 3-dimensional coordinate system.

16. An article manufacturing system of claim 9 wherein:
said tangible member includes a tool having a plurality of profile boards, at least one connector board, said profile boards including at least one profile edge, said profile edge of each of said profile boards located in a moldline surface which defines an image of said component part of said article, each of said profile boards further including locator means for fixedly locating said profile board with respect to said connector board, said connector board further including locator means for fixedly locating said connector board with respect to each of said profile boards, said respective locator means each includes a locator edge on said respective profile boards and said respective connector board.

17. A tool formed according to the method of claim 1, and having a defined surface which comprises:
a plurality of profile boards;
at least one connector board;
at least a portion of said profile boards including at least one profile edge, said profile edge forming at least a part of said defined surface of said tool;
each of said profile boards further including locator means for positioning said profile board with respect to said connector board;
said connector board further including locator means for positioning said connector board with respect to each of said profile boards;
said respective locator means each including a locator edge on said respective profile boards and said respective connector board;
said connector board locatable against said locator edge on said respective profile boards and said profile boards locatable against said locator edge on said connector board; and
means for maintaining said profile boards and said connector board fixedly positioned with respect to one another.

18. A tool of claim 17 including:
at least two of said connector boards, each of said connector boards further including locator means for positioning said respective connector board with respect to each of said profile boards.

19. A tool of claim 17 wherein:
each of said locator means includes a slot, each of said slots including a locator edge and a non-locator edge;
said locator edges of said respective profile boards abutting against said connector board to position said profile boards with respect to said connector board and said locator edges of said connector board abutting against said respective profile boards to position said connector board with respect to said respective profile boards;
said locator edges of said respective profile boards abutting against said connector board positioning said profile boards with respect to said connector board in 3-dimensional space in one of mutuality perpendicular X or Y axes;
said locator edges of said connector board abutting against said respective profile boards positioning said connector board with respect to said respective profile boards in 3-dimensional space in the other of said X or Y axes;
said tool being produced by further using:
Z axis positioning means for positioning each of said profile boards in 3-dimensional space in a Z axis, said Z axis orthogonal to said X and Y axes; and
said Z axis positioning means comprising each of said profile boards including a Z edge, said respective Z edge on each of said respective profile boards located in a fixed relationship with respect to the profile edge on said respective profile board.

20. A tool of claim 17 wherein:
said defined surface of said tool comprises a moldline surface; and wherein
said profile edge of each of said profile boards is located in said moldline surface.

21. A tool of claim 19 wherein:
said means for maintaining said profile boards and said connector board in fixed locations with respect to one another comprises a plurality of wedge means for essentially fixedly positioning one surface with respect to a further surface; and
one of said wedge means fitting into each of said respective slots on said respective profile boards and respective connector board, said respective wedge means in each respective slot fitting against both the non-locator edge of said respective slot and the respective board located in said respective slot to essentially fixedly position the respective board located in said respective slot against the locator edge of said respective slot.

## Patentansprüche

1. Verfahren zum Herstellen eines Vielkomponenten-Herstellungsgegenstands, wobei das Verfahren die folgenden Schritte enthält:
- Erzeugen einer Definition des Gegenstands mit Definitionen von Bestandteilen des Gegenstands als Grafikdatensatz in einer Datenbank in einem dreidimensionalen grafischen Computersystem, wobei die Definition Koordinatenpunkte aufweist, die die Definition des Gegenstands und der Bestandteile in einem dreidimensionalen Koordinatensystem genau plazieren, einer Definition mindestens einer Formungseinrichtung zum Herstellen von Bestandteilen des Gegenstands und einer Definition einer Zusammensetzeinrichtung zum Zusammensetzen von Bestandteilen des Gegenstands;
- Auswählen mindestens eines Teiles der Definition des Gegenstands, der Formungseinrichtung bzw. der Zusammensetzeinrichtung;
- Erzeugen eines weiteren Grafikdatensatzes durch Definieren virtueller Abbilder mindestens einer der Formungseinrichtungen und mindestens einer der Zusammensetzeinrichtungen, wobei die virtuellen Abbilder der Formungseinrichtungen und der Zusammensetzeinrichtungen die Koordinatenpunkte aufweisen;
- Herunterladen der Definitionen der Formungseinrichtungen, der Zusammensetzeinrichtungen und des weiteren Datensatzes aus dem Speicher des Computers in eine Einrichtung zum Herstellen von Formen;
- Betreiben der Einrichtungen zum Herstellen von Formen mit dem Datensatz und dem weiteren Datensatz als Eingangsdaten für die Formherstellungseinrichtung zum Herstellen von mindestens Teilen der Formungseinrichtung und der Zusammensetzeinrichtung und zum Lokalisieren von Koordinatenpunkten auf dem Teil der Formungseinrichtung und der Zusammensetzeinrichtung;
- Herstellen mit der Formungseinrichtung mindestens eines Teils des Bestandteils des Gegenstands, der dem ausgewählten Teil der Definition des Gegenstands entspricht; und
- Zusammensetzen des Bestandteils des Gegenstands mit der Zusammensetzeinrichtung zum schließlichen Herstellen des Vielkomponenten-Herstellungsgegenstands, wobei die Koordinatenpunkte auf der Formungseinrichtung und der Zusammensetzeinrichtung durch die in der Definition des Gegenstands enthaltenen Koordinatenpunkte auf entsprechende Punkte auf dem Bestandteil des Gegenstands verweisen.

2. Verfahren zum Herstellen eines Gegenstands nach Anspruch 1, weiter mit den folgenden Schritten:
wirksames Betreiben einer mikroprozessorgesteuerten Meßeinrichtung zusammen mit der Computereinrichtung zum Vermessen von Objekten im dreidimensionalen Raum und
Betreiben der Meßeinrichtung zum Vermessen von Punkten auf den Bestandteilen des Gegenstands zum Vergleich der Bestandteile mit der Definition des Gegenstands.

3. Verfahren zum Herstellen eines Gegenstands nach Anspruch 2, weiter mit dem folgenden Schritt:
Auswahl eines mikroprozessorgesteuerten Theodolitensystems als die mikroprozessorgesteuerte Meßeinrichtung.

4. Verfahren zum Herstellen eines Gegenstands nach Anspruch 1, bei dem
die Einrichtung zum Herstellen der Formungseinrichtung weiter eine computergestützte Formungskonstruktions-Softwareeinrichtung zum Definieren einer Abfolge von Maschinenvorgängen zum formenden (spanabhebenden) Bearbeiten von Teilen und eine computergestützte Formherstellungs-Softwareeinrichtung zum Eingeben der Abfolge von Vorgängen zum (spanabhebenden) Bearbeiten von Teilen in eine Werkzeugmaschine, wobei die Werkzeugmaschine Formungseinrichtungsteile (spanabhebend) herstellt, aufweist.

5. Verfahren zum Herstellen eines Gegenstands nach Anspruch 1, weiter mit den folgenden Schritten:
Zuordnen einer Ausgangseinrichtung zu dem Computersystem, wobei die Ausgangseinrichtung zum Ausgeben von Kopien von in der Datenbank in dem Computersystem enthaltenen Datensätzen dient;
Herunterladen des weiteren Datensatzes in die Ausgangseinrichtung zum Herstellen einer Kopie des weiteren Datensatzes;
Eingeben der Kopie des weiteren Datensatzes in eine mikroprozessorgesteuerte optische Meßeinrichtung, wobei die Meßeinrichtung zum Vermessen von Objekten im dreidimensionalen Raum dient; und
Betreiben der optischen Meßeinrichtung zum Vermessen der Koordinatenpunkte auf der Formungseinrichtung und der Zusammensetzeinrichtung zum Vergleichen der Formungseinrichtung und der Zusammensetzeinrichtung mit den virtuellen Abbildern der Formungseinrichtung und der Zusammensetzeinrichtung in dem Datensatz.

6. Verfahren zum Herstellen eines Gegenstands nach Anspruch 1, weiter mit den folgenden Schritten:
Auswahl der Einrichtung zum Herstellen von Formen aus einer Gruppe, die die folgenden Werkzeuge enthält: NC-Werkzeugmaschinen, NC-Laserschneidemaschinen, NC-Roboter, CNC-Werkzeugmaschinen, CNC-Laserschneidemaschinen und CNC-Roboter.

7. Verfahren zum Herstellen eines Gegenstands nach Anspruch 1, bei dem
die Formungseinrichtung eine Form enthält, die mehrere Profilpanele, mindestens eine Verbindungsplatte, wobei die Profilpanele mindestens eine Profilkante aufweisen, wobei die Profilkante eines jeden Profilpanels in einer Formoberfläche liegt, die ein Abbild des Bestandteils des Gegenstands festlegt, wobei jedes Profilpanel weiter eine Plazierungseinrichtung zum festen Plazieren des Profilpanels auf der Verbindungsplatte aufweist, wobei die Verbindungsplatte weiter Plazierungseinrichtungen zum festen Plazieren der Verbindungsplatte bezüglich der jeweiligen Profilpanele aufweist, wobei die entsprechenden Plazierungseinrichtungen jeweils eine Plazierungskante auf dem entsprechenden Profilpanel und der entsprechenden Verbindungsplatte aufweisen.

8. Verfahren zum Herstellen eines Gegenstands nach Anspruch 1, bei dem
die Formungseinrichtung eine Formeinrichtung zum Herstellen von Bestandteilen des Gegenstands aufweist;
wobei die Formeinrichtung folgende Bestandteile aufweist: eine Oberfläche; mehrere Zieleinrichtungen zum Festlegen eines genau bekannten räumlichen Verhältnisses in einem dreidimensionalen Koordinatensystem, wobei die mehreren Zieleinrichtungen zum Festlegen genau bekannter auf der Oberfläche liegender Positionen auf der Oberfläche angebracht sind; eine Abbildungsform, wobei die Abbildungsform ein Abbild eines Bestandteils des Gegenstands enthält, wobei die Abbildungsform auf der Oberfläche in einem bekannten Verhältnis mit der räumlichen Einrichtung plazierbar ist; und eine auf der Abbildungsform und der Oberfläche gebildete Komplementärform, wobei die Komplementärform ein Komplementärabbild des Gegenstandbestandteils und weiterhin ein Abbild der räumlichen Einrichtung auf der Oberfläche aufweist; und
das Abbild der Zieleinrichtung auf der Komplementärform genau bekannte Positionen auf der Komplementärform definiert, die im Verhältnis zum Komplementärabbild des Gegenstandsbestandteils auf der Komplementärform genau plaziert sind, damit das Komplementärbild des Teils im Verhältnis zum dreidimensionalen Koordinatensystem genau definiert werden kann, wodurch bei der Formung eines Gegenstandsteils auf der Komplementärform Punkte auf dem Teil im Verhältnis zum dreidimensionalen Koordinatensystem genau bekannt sind.

9. Vielkomponentengegenstand-Herstellungssm mit
- einem dreidimensionalen Grafik-Computersystem mit einem grafischen Datenmodell eines Gegenstands in einer Datenbank in dem Computersystem; wobei der Gegenstand mehrere Bestandteile aufweist;
- wobei das Computersystem eine Einrichtung zum Definieren einer grafischen virtuellen Oberfläche in dem Datenmodell des Gegenstands als einem der Bestandteile enthält;
- wobei das Computersystem eine Einrichtung zum Definieren eines grafischen virtuellen Elements in dem Datenmodell des Gegenstands aufweist, wobei das virtuelle Element mindestens einen Teil der grafischen virtuellen Oberfläche umfaßt;
- wobei das Computersystem eine Einrichtung zum Definieren mindestens einer Formungseinrichtung zum Herstellen von Bestandteilen des Gegenstands als ein weiteres grafisches virtuelles Element aufweist;
- wobei das Computersystem eine Einrichtung zum Definieren einer Zusammensetzeinrichtung zum Zusammensetzen von Bestandteilen des Gegenstands als ein weiteres grafisches virtuelles Element aufweist;
wobei das System weiter aufweist:
- eine Einrichtung zum Herstellen eines materiellen Elements, die bestimmten der grafischen virtuellen Elemente entsprechen, wobei die Einrichtung zum Herstellen eines materiellen Elements über eine Schnittstelle wirksam mit dem Computer verbunden ist;
- eine Einrichtung, die zum Herunterladen der Definition des grafischen virtuellen Elements aus dem Datenmodell in die Einrichtung zum Herstellen eines materiellen Elements mit dem Computer wirksam verbunden ist, wobei die letztere Einrichtung ein dem grafischen virtuellen Element entsprechendes materielles Element herstellt;
- eine Einrichtung zum Zusammensetzen der materiellen Elemente zum Herstellen des Gegenstands, wobei die räumlichen Beziehungen der materiellen Elemente den grafischen virtuellen Elementen des Gegenstands entsprechen, wobei die Formungseinrichtung und die Zusammensetzeinrichtung über Koordinatenpunkte auf den materiellen Elementen, die Koordinatenpunkten in den grafischen virtuellen Elementdefinitionen entsprechen, miteinander in Beziehung gebracht werden.

10. Gegenstandsherstellungssystem nach Anspruch 9, weiter mit
einer mikroprozessorgesteuerten Meßeinrichtung zum Vermessen von Punkten auf dem materiellen Element und zum Vergleichen der Meßpunkte mit der Definition des Gegenstands in der Computerdatenbank.

11. Gegenstandsherstellungssystem nach Anspruch 9, bei dem
die Einrichtung zum Herstellen materieller Elemente eine Abbildungseinrichtung aufweist, die entweder eine Abbildungskopie oder eine Komplementär-Abbildungskopie mindestens eines Teils des Gegenstands herstellt.

12. Gegenstandsherstellungssystem nach Anspruch 9, bei dem
die entsprechenden Einrichtungen zum Definieren der grafischen virtuellen Oberfläche und zum Definieren des grafischen virtuellen Elements eine Benutzerschnittstelleneinrichtung zum Eingeben von Befehlen in das Computersystem aufweisen, wobei die Benutzerschnittstelleneinrichtung in wirksamer Verbindung mit dem Computersystem steht.

13. Gegenstandsherstellungssystem nach Anspruch 9, bei dem
die entsprechenden Einrichtungen zum Definieren der grafischen virtuellen Oberfläche und zum Definieren des grafischen virtuellen Elements eine computergestützte Formungskonstruktions-Softwareeinrichtung zum Definieren einer Abfolge von Maschinenvorgängen zum spanabhebenden Herstellen eines materiellen Teils aufweist; und
die Einrichtung zum Herstellen eines materiellen Elements eine computergestützte Formungsherstellungs-Softwareeinrichtung zum Eingeben der Abfolge von Maschinenvorgängen an eine Werkzeugeinrichtung aufweist, wobei die Werkzeugeinrichtung einen materiellen Teil herstellt, der eine Nachahmung des grafischen virtuellen Elements im Datenmodell des Gegenstands ist.

14. Gegenstandsherstellungssystem nach Anspruch 9, bei dem
die Einrichtung zum Herstellen eines materiellen Elements mindestens eine NC-Werkzeugeinrichtung zum Herstellen eines Teils umfaßt und bei dem die NC-Werkzeugeinrichtung aus einer Gruppe ist, die die folgenden Werkzeuge enthält: NC-Werkzeugmaschinen, NC-Laserschneidemaschinen, NC-Roboter, CNC-Werkzeugmaschinen, CNC-Laserschneidemaschinen und CNC-Roboter.

15. Gegenstandsherstellungssystem nach Anspruch 9, bei dem
das Datenmodell des Gegenstands Koordinatenpunkte enthält, die ein genaues Plazieren einer Konstruktionsdefinition des Gegenstands in einem dreidimensionalen Koordinatensystem erlauben, und
die Einrichtung zum Herunterladen der Definition des virtuellen Elements in dem Datenmodell eine Einrichtung aufweist, mit der Koordinatenpunkte in dem virtuellen Element angebracht werden können, die ein genaues Plazieren des virtuellen Elements in dem dreidimensionalen Koordinatensystem erlauben.

16. Gegenstandsherstellungssystem nach Anspruch 9, bei dem
das materielle Element eine Form mit mehreren Profilpanelen, mindestens einer Verbindungsplatte, wobei die Profilpanele mindestens eine Profilkante aufweisen, wobei die Profilkante eines jeden Profilpanels in einer Formoberfläche liegt, die ein Abbild des Bestandteils des Gegenstands festlegt, wobei jedes Profilpanel weiter eine Plazierungseinrichtung zum festen Plazieren des Profilpanels auf der Verbindungsplatte aufweist, wobei die Verbindungsplatte weiter Plazierungseinrichtungen zum festen Plazieren der Verbindungsplatte bezüglich der jeweiligen Profilpanele aufweist, wobei die entsprechenden Plazierungseinrichtungen jeweils eine Plazierungskante auf dem entsprechenden Profilpanel und der entsprechenden Verbindungsplatte aufweisen.

17. Nach dem Verfahren nach Anspruch 1 hergestellte Form, die eine definierte Oberfläche hat und folgendes umfaßt:
mehrere Profilpanele,
mindestens eine Verbindungsplatte,
wobei die Profilpanele mindestens eine Profilkante aufweisen, wobei die Profilkante eines jeden Profilpanels in einer Formoberfläche liegt, die ein Abbild des Bestandteils des Gegenstands festlegt,
wobei jedes Profilpanel weiter eine Plazierungseinrichtung zum festen Plazieren des Profilpanels auf der Verbindungsplatte aufweist,
wobei die Verbindungsplatte weiter Plazierungseinrichtungen zum festen Plazieren der Verbindungsplatte bezüglich der jeweiligen Profilpanele aufweist,
wobei die entsprechenden Plazierungseinrichtungen jeweils eine Plazierungskante auf dem entsprechenden Profilpanel und der entsprechenden Verbindungsplatte aufweisen,
wobei die Verbindungsplatte gegen die Plazierungskante auf dem entsprechenden Profilpanel und die Profilpanele gegen die Plazierungskante auf der Verbindungsplatte plazierbar sind, und
eine Einrichtung zum Halten der Profilpanele und der Verbindungsplatte in einer festen Position zueinander.

18. Form nach Anspruch 17, mit
mindestens zwei der Verbindungsplatten, wobei jede der Verbindungsplatten weiter eine Plazierungseinrichtung zum Plazieren der entsprechenden Verbindungsplatte bezüglich der jeweiligen Profilpanele aufweist.

19. Form nach Anspruch 17, bei dem
jede Plazierungseinrichtung einen Schlitz umfaßt, wobei jeder der Schlitze eine Plazierungskante und eine Nicht-Plazierungskante hat;
wobei die Plazierungskanten der jeweiligen Profilpanele an die Verbindungsplatte anstoßen, um die Profilpanele bezüglich der Verbindungsplatte zu plazieren, und die Plazierungskanten der Verbindungsplatte gegen die jeweiligen Profilpanele stoßen, um so die Verbindungsplatte bezüglich der entsprechenden Profilpanele zu plazieren;
wobei die Plazierungskanten der entsprechenden Profilpanele an die Verbindungsplatte anstoßen, wodurch die Profilpanele in bezug auf die Verbindungsplatte im dreidimensionalen Raum in einer von aufeinander senkrecht stehenden Achsen, der X- oder der Y-Achse, positioniert werden;
wobei die Plazierungskanten der Verbindungsplatte an die entsprechenden Profilpanele anstoßen, wodurch die Verbindungsplatte in bezug auf die entsprechenden Profilpanele im dreidimensionalen Raum in der anderen der beiden Achsen, der X- oder der Y-Achse, plaziert wird;
wobei die Form hergestellt wird durch Verwendung von:
Z-Achsen-Positionierungseinrichtungen zum Positionieren der jeweiligen Profilpanele im dreidimensionalen Raum in einer Z-Achse, wobei die Z-Achse zu der X- und der Y-Achse senkrecht ist, und
wobei die Z-Achsen-Positionierungseinrichtungen darin bestehen, daß jedes der Profilpanele eine Z-Kante aufweist, wobei die jeweiligen Z-Kanten auf den jeweiligen entsprechenden Profilpanelen in einer festen Beziehung zur Profilkante des entsprechenden Profilpanels stehen.

20. Form nach Anspruch 17, bei der
die definierte Oberfläche der Form eine Formoberfläche beinhaltet und bei der
jeweils die Profilkante der Profilpanele in der Formoberfläche liegt.

21. Form nach Anspruch 19, bei der
die Einrichtung zum Halten der Profilpanele und der Verbindungsplatte in festen Positionen zueinander mehrere Keileinrichtungen umfaßt, mit denen eine Oberfläche im wesentlichen fest zu einer anderen positioniert werden kann; und
eine der Keileinrichtungen jeweils in einen der entsprechenden Schlitze auf den entsprechenden Profilpanelen und der entsprechenden Verbindungsplatte paßt, wobei die entsprechenden Keileinrichtungen in den jeweiligen entsprechenden Schlitzen sowohl gegen die Nicht-Positionierungskante des entsprechenden Schlitzes als auch die entsprechende in dem entsprechenden Schlitz befindliche Platte drückt, wodurch die in dem entsprechenden Schlitz befindliche Platte gegen die Positionierungskante des entsprechenden Schlitzes im wesentlichen fest positioniert wird.

## Revendications

1. Procédé de fabrication d'un article de fabrication à plusieurs éléments, lequel procédé comprend :
- la création d'une définition dudit article y compris les définitions des pièces détachées dudit article, comme ensemble de données graphiques dans une base de données d'un système informatique graphique en 3 dimensions, ladite définition comportant des points de coordonnées situant avec précision ladite définition dudit article et desdites pièces détachées dans un système de coordonnées en 3 dimensions, la création d'une définition d'au moins un moyen d'outil de façonnage destiné à former des pièces détachées dudit article et d'une définition d'un moyen d'outil d'assemblage destiné à assembler des pièces détachées dudit article ;
- la sélection d'au moins une partie desdites définitions dudit article, dudit moyen d'outil de façonnage et dudit moyen d'outil d'assemblage, respectivement ;
- la création d'un autre ensemble de données graphiques en définissant des images virtuelles d'au moins un desdits moyens d'outil de façonnage et d'au moins un desdits moyens d'outil d'assemblage, lesdites images virtuelles desdits moyens d'outil de façonnage et desdits moyens d'outil d'assemblage comportant lesdits points de coordonnées ;
- le téléchargement desdites définitions desdits moyens d'outil de façonnage, desdits moyens d'outil d'assemblage et dudit ensemble supplémentaire de données à partir de la mémoire dudit ordinateur vers des moyens destinés à faire des outils ;
- l'exploitation desdits moyens destinés à fabriquer des outils avec lesdites données et l'ensemble supplémentaire de données comme entrée vers lesdits moyens destinés à fabriquer des outils pour former au moins des parties desdits moyens d'outil de façonnage et desdits moyens d'outil d'assemblage et pour situer des points de coordination sur ladite partie desdits moyens d'outil de façonnage et desdits moyens d'outils d'assemblage ;
- la formation avec lesdits moyens d'outils de façonnage d'au moins une partie de la pièce détachée dudit article correspondant à ladite partie choisie de ladite définition dudit article ; et
- l'assemblage de ladite pièce détachée dudit article avec lesdits moyens d'outil d'assemblage, pour fabriquer en définitive ledit article de fabrication à plusieurs éléments, pendant lequel lesdits points de coordination se trouvant sur lesdits moyens d'outil de façonnage et lesdits moyens d'outil d'assemblage sont renvoyés à des points correspondants sur ladite pièce détachée dudit article au moyen des points de coordonnées compris dans la définition dudit article.

2. Procédé de fabrication d'un article de la revendication 1 comportant :
l'association fonctionnelle avec ledit système informatique de moyens de mesure commandés par microprocesseur, destinés à mesurer des objets dans un espace en 3 dimensions ; et
l'exploitation desdits moyens de mesure pour mesurer des points sur lesdites pièces détachées dudit article pour comparer lesdites pièces détachées avec ladite définition dudit article.

3. Procédé de fabrication d'un article de la revendication 2 comprenant :
la sélection d'un système de théodolite commandé par microprocesseur comme dispositif de mesure commandé par microprocesseur.

4. Procédé de fabrication d'un article de la revendication 1 dans lequel :
ledit moyen destiné à fabriquer les moyens d'outil de façonnage comprend de plus des moyens de logiciel de conception d'outillage assistée par ordinateur pour définir une séquence d'opérations machine destinées à usiner des pièces d'outillage et des moyens de logiciel de fabrication d'outillage assistée par ordinateur pour entrer ladite séquence d'opérations destinées à l'usinage de pièces d'outillage sur une machine-outil, ladite machine-outil usinant des pièces détachées d'outil de façonnage.

5. Procédé de fabrication d'un article de la revendication 1 comportant :
l'association de moyens de sortie avec ledit système informatique, lesdits moyens de sortie destinés à sortir des copies d'ensembles de données dans ladite base de données dans ledit système informatique ;
le téléchargement dudit ensemble de données supplémentaire sur ledit dispositif de sortie pour former une copie dudit ensemble de données supplémentaire ;
l'entrée de ladite copie dudit ensemble de données supplémentaire sur des moyens de mesure optique commandés par microprocesseur, lesdits moyens de mesure étant destinés à mesurer des objets dans un espace en 3 dimensions ; et
l'exploitation desdits moyens de mesure optique pour mesurer lesdits points de coordination sur lesdits moyens d'outil de façonnage et lesdits moyens d'outil d'assemblage pour comparer lesdits moyens d'outil de façonnage et lesdits moyens d'outils d'assemblage avec lesdites images virtuelles desdits moyens d'outil de façonnage et desdits moyens d'outil d'assemblage dans ledit ensemble de données.

6. Procédé de fabrication d'un article de la revendication 1 comportant de plus :
la sélection desdits moyens destinés à fabriquer des outils parmi un ensemble d'outils composés de machines-outils à commande numérique, de découpeuses à laser à commande numérique, de robots à commande numérique, de machines-outils à commande numérique par ordinateur, de découpeuses à laser à commande numérique par ordinateur et de robots à commande numérique par ordinateur.

7. Procédé de fabrication d'un article de la revendication 1 dans lequel :
ledit moyen d'outil de façonnage comporte un outil présentant une pluralité de plaques de profilé, au moins une plaque de raccord, lesdites plaques de profilé comportant au moins un bord de profilé, ledit bord de profilé de chacune desdites plaques de profilé étant situé dans une surface de ligne de moulage qui définit une image de ladite pièce détachée dudit article, chacune desdites plaques de profilé comportant de plus des moyens positionneurs destinés à situer fixement ladite plaque de profilé par rapport à ladite plaque de raccord, ladite plaque de raccord comportant encore des moyens positionneurs destinés à situer fixement ladite plaque de raccord par rapport à chacune des plaques de profilé, lesdits moyens positionneurs respectifs comportant chacun un bord positionneur sur lesdites plaques de profilé respectives et ladite plaque de raccord respective.

8. Procédé de fabrication d'un article de la revendication 1 dans lequel :
ledit moyen d'outil de façonnage comporte un moyen de moulage destiné à former des pièces détachées dudit article ;
ledit moyen de moulage comportant : une surface ; une pluralité de moyens de cible destinés à définir une relation dans l'espace connue avec précision dans un système de coordonnées en 3 dimensions, ladite pluralité de moyens de cible étant située sur ladite surface pour définir des positions connues avec précision sur ladite surface ; un moule image, ledit moule image comportant une image d'une pièce détachée dudit article, ledit moule image pouvant être situé sur ladite surface dans une association connue avec ledit moyen d'espace ; et un moule complémentaire formé sur ledit moule image et ladite surface, ledit moule complémentaire comportant une image complémentaire de ladite pièce détachée d'article et comportant aussi une image dudit moyen d'espace sur ladite surface ; et
ladite image desdits moyens de cible sur ledit moule complémentaire définissant avec précision des positions connues sur ledit moule complémentaire qui sont situées avec précision par rapport à ladite image complémentaire de ladite pièce détachée de l'article sur ledit moule complémentaire pour définir avec précision ladite image complémentaire de ladite pièce par rapport au système de coordonnées en 3 dimensions par lequel lorsqu'une pièce d'article est moulée sur ledit moule complémentaire, des points sur ladite pièce sont connus avec précision par rapport audit système de coordonnées en 3 dimensions.

9. Système de fabrication d'article à plusieurs éléments qui comprend :
- un système informatique graphique en 3 dimensions renfermant une structure de données graphique d'un article d'une base de données dans ledit système informatique ; ledit article comportant une pluralité de pièces détachées ;
- ledit système informatique comportant des moyens destinés à définir une surface virtuelle graphique dans ladite structure de données dudit article comme une desdites pièces détachées ;
- ledit système informatique comportant des moyens destinés à définir un élément virtuel graphique dans ladite structure de données dudit article, ledit élément virtuel comportant au moins une partie de ladite surface virtuelle graphique ;
- ledit système informatique comportant des moyens destinés à définir au moins un moyen d'outil de façonnage destiné à former des pièces détachées dudit article en tant qu'élément virtuel graphique supplémentaire ;
- ledit système informatique comportant des moyens destinés à définir un moyen d'outil d'assemblage destiné à assembler des pièces détachées dudit article, comme élément virtuel graphique supplémentaire ;
le système comportant aussi :
- un moyen destiné à former un élément tangible qui correspond à un certain élément parmi lesdits éléments graphiques virtuels, ledit moyen destiné à former un élément tangible étant en interface de façon fonctionnelle avec ledit système informatique ;
- un moyen associé de façon fonctionnelle avec ledit système informatique destiné à télécharger ladite définition dudit élément virtuel graphique dans ladite structure de données sur ledit moyen destiné à former un élément tangible, ce dernier moyen formant un élément tangible correspondant audit élément virtuel graphique ;
- un moyen destiné à assembler lesdits éléments tangibles pour former ledit article, grâce auquel les relations dans l'espace des éléments tangibles correspondant auxdits éléments virtuels graphiques dudit article, ledit moyen d'outil de façonnage et ledit moyen d'outil d'assemblage font référence les uns aux autres au moyen de points de coordination se trouvant sur lesdits éléments tangibles qui correspondent à des points de coordonnées dans lesdites définitions d'élément virtuel graphique.

10. Système de fabrication d'article de la revendication 9 comportant aussi :
un moyen de mesure commandé par microprocesseur destiné à mesurer des points se trouvant sur ledit élément tangible et à comparer lesdits points de mesure à ladite définition dudit article dans ladite base de données informatique.

11. Système de fabrication d'article de la revendication 9, par lequel :
ledit moyen de façonnage de l'élément tangible comprend un moyen d'outil image destiné à former soit une copie image, soit une copie image complémentaire d'au moins une partie dudit article.

12. Système de fabrication d'article de la revendication 9, dans lequel :
ledit moyen respectif destiné à définir ladite surface virtuelle graphique et à définir ledit élément virtuel graphique comporte un moyen d'interface d'exploitation destiné à entrer des commandes sur ledit système informatique, ledit moyen d'interface d'exploitation étant associé de façon fonctionnelle avec ledit système informatique.

13. Système de fabrication d'article de la revendication 9, dans lequel :
ledit moyen respectif destiné à définir ladite surface virtuelle graphique et à définir ledit élément virtuel graphique comporte un moyen de logiciel de conception d'outillage assistée par ordinateur destiné à définir une séquence d'opérations machine pour usiner une pièce tangible ; et
ledit moyen destiné à former un élément tangible comporte un moyen de logiciel pour la fabrication d'outillage assistée par ordinateur destiné à entrer ladite séquence d'opérations machine sur un moyen d'outil, par lequel ledit moyen d'outil forme une pièce tangible qui est une réplique dudit élément virtuel graphique dans ladite structure de données dudit article.

14. Système de fabrication d'article de la revendication 9, dans lequel :
ledit moyen destiné à former un élément tangible comporte au moins un moyen d'outil à commande numérique destiné à former une pièce et où ledit moyen d'outil à commande numérique est sélectionné parmi des moyens d'outils composés de machines-outils à commande numérique, de découpeuses à laser à commande numérique, de robots à commande numérique, de machines-outils à commande numérique par ordinateur, de découpeuses à laser à commande numérique par ordinateur et de robots à commande numérique par ordinateur.

15. Système de fabrication d'article de la revendication 9, dans lequel
ladite structure de données dudit article comporte des points de coordonnées destinés à situer avec précision une définition de conception dudit article dans un système de coordonnées en 3 dimensions ; et
ledit moyen destiné à télécharger ladite définition dudit élément virtuel dans ladite structure de données comporte des moyens destinés à comprendre des points de coordonnées sur ledit élément virtuel situant avec précision ledit élément virtuel dans ledit système de coordonnées en 3 dimensions.

16. Système de fabrication d'un article de la revendication 9, dans lequel :
ledit élément tangible comporte un outil présentant une pluralité de plaques de profilé, au moins une plaque de raccord, lesdites plaques de profilé comportant au moins un bord de profilé, ledit bord de profilé de chacune desdites plaques de profilé situées dans une surface de ligne de moulage définissant une image de ladite pièce détachée dudit article, chacune desdites plaques de profilé comportant aussi des moyens positionneurs destinés à situer de façon fixe ladite plaque de profilé par rapport à ladite plaque de raccord, ladite plaque de raccord comportant aussi des moyens positionneurs destinés à situer de façon fixe ladite plaque de raccord par rapport à chacune desdites plaques de profilé, lesdits moyens positionneurs respectifs comportant chacun un bord positionneur sur lesdites plaques de profilé respectives et ladite plaque de raccord respective.

17. Outil formé selon le procédé de la revendication 1 et présentant une surface définie qui comporte :
une pluralité de plaques de profilé ;
au moins une plaque de raccord ;
au moins une partie desdites plaques de profilé comportant au moins un bord de profilé, ledit bord de profilé formant au moins une pièce de ladite surface définie dudit outil ;
chacune desdites plaques de profilé comportant aussi des moyens positionneurs destinés à positionner ladite plaque de profilé par rapport à ladite plaque de raccord ;
ladite plaque de raccord comportant aussi des moyens positionneurs destinés à positionner ladite plaque de raccord par rapport à chacune desdites plaques de profilé ;
lesdits moyens positionneurs respectifs comportant chacun un bord positionneur sur lesdites plaques de profilé respectives et ladite plaque de raccord respective ;
ladite plaque de raccord pouvant être située contre ledit bord positionneur sur lesdites plaques de profilé respectives et lesdites plaques de profilé pouvant être situées contre ledit bord positionneur sur ladite plaque de raccord ; et
des moyens destinés à maintenir lesdites plaques de profilé et ladite plaque de raccord dans un positionnement fixe les unes par rapport aux autres.

18. Outil de la revendication 17 comportant :
au moins deux desdites plaques de raccord, chacune desdites plaques de raccord comportant aussi des moyens positionneurs destinés à positionner ladite plaque de raccord respective par rapport à chacune desdites plaques de profilé.

19. Outil de la revendication 17, dans lequel :
chacun desdits moyens positionneurs comporte une fente, chacune desdites fentes comportant un bord positionneur et un bord non positionneur ;
lesdits bords positionneurs desdites plaques de profilé respectives venant en butée contre ladite plaque de raccord pour positionner lesdites plaques de profilé par rapport à ladite plaque de raccord et lesdits bords positionneurs de ladite plaque de raccord venant en butée contre lesdites plaques de profilé respectives pour positionner ladite plaque de raccord par rapport auxdites plaques de profilé respectives ;
lesdits bords positionneurs desdites plaques de profilé respectives venant en butée contre ladite plaque de raccord en positionnant lesdites plaques de profilé par rapport à ladite plaque de raccord dans un espace en 3 dimensions dans l'un des axes orthogonaux X ou Y ;
lesdits bords positionneurs de ladite plaque de raccord venant en butée contre lesdites plaques de profilé respectives positionnant ladite plaque de raccord par rapport auxdites plaques de profilé respectives dans un espace en 3 dimensions dans les autres axes X ou Y ;
ledit outil étant produit en utilisant aussi :
des moyens de positionnement de l'axe Z destinés à positionner chacune desdites plaques de profilé dans un espace en 3 dimensions dans un axe Z, ledit axe Z étant orthogonal auxdits axes X et Y ; et
lesdits moyens de positionnement de l'axe Z comprenant chacune desdites plaques de profilé comportant un bord Z, ledit bord Z respectif se trouvant sur chacune desdites plaques de profilé respectives situées dans une relation fixe par rapport au bord de profilé se trouvant sur ladite plaque de profilé respective.

20. Outil de la revendication 17, dans lequel :
ladite surface définie dudit outil comprend une surface de ligne de moulage ; et dans lequel
ledit bord de profilé de chacune desdites plaques de profilé est situé dans ladite surface de ligne de moulage.

21. Outil de la revendication 19, dans lequel :
ledit moyen de maintien desdites plaques de profilé et de ladite plaque de raccord dans des emplacements fixes les uns par rapport aux autres comprend une pluralité de moyens de clavette destinés à positionner essentiellement de façon fixe une surface par rapport à une autre surface ; et
l'un desdits moyens de clavette s'emboîtant dans chacune desdites fentes respectives sur lesdites plaques de profilé respectives et ladite plaque de raccord respective, lesdits moyens respectifs de clavette se trouvant dans chaque fente respective s'insérant à la fois contre le bord non positionneur de ladite fente respective et ladite plaque respective située dans ladite fente respective pour positionner essentiellement de façon fixe la plaque respective située dans ladite fente respective contre le bord positionneur de ladite fente respective.
